# EUROPEAN PATENT SPECIFICATION

(11) **EP 4 215 958 B1**
(45) Date of publication and mention of the grant of the patent: **05.11.2025**
(21) Application number: 23152037.0
(22) Date of filing: 17.01.2023
(51) Int. Cl.: H10F 39/18, H10F 39/00, G02B 3/00, G02B 5/20

(54) **IMAGE SENSOR, ELECTRONIC DEVICE INCLUDING THE IMAGE SENSOR AND METHOD OF MANUFACTURING THE IMAGE SENSOR**
BILDSENSOR, ELEKTRONISCHE VORRICHTUNG MIT DEM BILDSENSOR UND VERFAHREN ZUR HERSTELLUNG DES BILDSENSORS
CAPTEUR D'IMAGE, DISPOSITIF ÉLECTRONIQUE COMPRENANT LE CAPTEUR D'IMAGE ET PROCEDE DE FABRICATION DU CAPTEUR D'IMAGE

(30) Priority: 24.01.2022 KR 20220010221
(43) Date of publication of application: 26.07.2023
(73) Proprietor: Samsung Electronics Co., Ltd., Gyeonggi-do 16677 (KR)
(72) Inventor: ROH, Sookyoung, 16678, Suwon-si, (KR); YUN, Seokho, 16678, Suwon-si, (KR); LEE, Sangyun, 16678, Suwon-si, (KR)
(74) Representative: Elkington and Fife LLP

(56) References cited:
- EP-A1- 3 812 801
- KR-A- 20210 048 987
- US-A1- 2005 285 215
- US-A1- 2015 098 006
- YUN SEOKHO ET AL: "Highly Efficient Color Separation and Focusing in the Sub-micron CMOS Image Sensor", 2021 IEEE INTERNATIONAL ELECTRON DEVICES MEETING (IEDM), IEEE, 11 December 2021 (2021-12-11), XP034096718, DOI: 10.1109/IEDM19574.2021.9720592

## Description

### FIELD OF THE INVENTION

The disclosure relates to an image sensor and an electronic device including the image sensor, and a method of manufacturing the image sensor.

### BACKGROUND OF THE INVENTION

An image sensor senses the color of incident light by using a color filter. However, since a color filter absorbs light of colors other than light of a corresponding color, light utilization efficiency may be reduced. For example, in case of using RGB color filters, only one-third of incident light is transmitted therethrough and the remaining two-thirds are absorbed, and thus light use efficiency is only about 33%. Therefore, in the case of a color display device or a color image sensor, most of light loss occurs in a color filter. Therefore, a method of efficiently separating colors without using a color filter in an image sensor has been continuously researched.

Recently, various attempts have been made with regard to color separation elements using high refractive index nano-structures having sub-wavelength shape dimensions. These nano-structures may be designed to have a phase profile capable of splitting light according to respective wavelengths.

EP 3812801 A1 describes an image sensor including a color separating lens array, the image sensor including a sensor substrate including a plurality of first photosensitive cells.

KR 2021 0048987 A describes an image sensor and an electronic device including the same. The disclosed image sensor comprises a color separation element.

Yun Seokho et al., "Highly Efficient Color Separation and Focusing in the Submicron CMOS Image Sensor*",* describes a nanoscale metaphotonic color-routing structure that can significantly improve low-light performance.

US 2005/285215 A1 describes integrated circuit devices including a semiconductor substrate and a sensor array region including a plurality of photoelectric conversion elements.

US 2015/098006 A1 describes a solid-state image pickup apparatus including an image pickup pixel and a focus detection pixel. The image pickup pixel includes a micro lens and a photoelectric conversion unit.

### SUMMARY OF THE INVENTION

Provided are an image sensor having a color separation lens array having a structure capable of reducing process errors and a method of manufacturing the image sensor.

Additional aspects will be set forth in part in the description which follows and, in part, will be apparent from the description, or may be learned by practice of the presented example embodiments of the disclosure.

Embodiments may provide a color pixel array structure including multiple nano-photonic color sorting layers and its fabrication method.

According to an aspect of the disclosure, there is provided an image sensor according to claim 1.

A smallest width from among the widths of first nano-posts may be arranged in the narrow-CD layer is 50 nm or greater.

A smallest width from among widths of second nano-posts may be arranged in the wide-CD layer is 100 nm or greater.

The image sensor includes a first etch stop layer provided between the transparent spacer layer and color separation lens array.

The image sensor may include a second etch stop layer provided between the wide-CD layer and the narrow-CD layer.

The one or more fourth nano-posts in the narrow-CD layer may be directly connected to the second nano posts in the wide-CD layer in a vertical direction.

A width of the one or more fourth nano-posts may be connected to each other in the vertical direction is 100 nm or greater.

The second nano-posts of the wide-CD layer may have a first height lower than a second height of the first nano-posts of the narrow-CD layer.

The first height of the nano-posts of the wide-CD layer may be 400 nm or less.

A thickness of the first etch stop layer may be in a range from about 10 nm to about 30 nm.

A thickness of the second etch stop layer may be in a range from about 3 nm to about 25 nm.

The narrow-CD layer is provided closer to the transparent spacer layer than the wide-CD layer.

The one or more fourth nano-posts in the narrow-CD layer may be directly connected to the second nano posts in the wide-CD layer in a vertical direction.

No etch stop layer may be provided between the narrow-CD layer and the wide-CD layer.

A thickness of the first etch stop layer may be in a range from about 10 nm to about 30 nm.

The color separation lens array may be configured to separate light of a first wavelength and light of a second wavelength from incident light and converge the light of the first wavelength to a first pixel and the light of the second wavelength to a second pixel of the plurality of light sensing cells.

The image sensor may include a color filter array provided between the transparent spacer layer and the sensor substrate.

According to another aspect of the disclosure, there is provided an electronic device according to claim 11.

According to another aspect of the disclosure, there is provided a method of manufacturing an image sensor according to claim 12.

The method may include forming a second etch stop layer between the first material layer and the second material layer.

In the patterning operation, a plurality of holes having a width less than the reference width and a depth exposing the second etch stop layer are formed together with the plurality of holes having a width greater than the reference width.

A thickness of the second material layer may be greater than a thickness of the first material layer.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a block diagram of an image sensor according to an example embodiment.
FIGS. 2A and 2B are conceptual views of a schematic structure and operation of a color separation lens array provided in an image sensor according to an example which does not fall within the scope of the claims.
FIG. 3 is a plan view of a color arrangement indicated by a pixel array of an image sensor according to an example embodiment.
FIGS. 4A and 4B are cross-sectional views of a pixel array of an image sensor according to an example embodiment viewed from different cross-sections, respectively.
FIG. 5A is a plan view of the arrangement of a pixel corresponding region of a color separation lens array provided in a pixel array according to an example embodiment, and FIG. 5B is a plan view of a pixel arrangement of a sensor substrate provided in the pixel array.
FIG. 6A shows phase profiles of green light and blue light that passed through a color separation lens array in the cross section of FIG. 4A, FIG. 6B shows phase of green light that passed through the color separation lens array at centers of pixel corresponding regions, and FIG. 6C shows phase of blue light that passed through the color separation lens array at centers of the pixel corresponding regions.
FIG. 6D is a diagram showing an example of a traveling direction of green light incident on a first green light converging region, and FIG. 6E is a diagram showing an example of an array of the first green light converging region.
FIG. 6F is a diagram showing an example of a traveling direction of blue light incident on a blue light converging region, and FIG. 6G is a diagram showing an example of an array of the blue light converging region.
FIG. 7A shows phase profiles of red light and green light that passed through a color separation lens array in the cross section of FIG. 4A, FIG. 7B shows phase of red light that passed through the color separation lens array at centers of pixel corresponding regions, and FIG. 7C shows phase of green light that passed through the color separation lens array at centers of the pixel corresponding regions.
FIG. 7D is a diagram showing an example of a traveling direction of red light incident on a red light converging region, and FIG. 7E is a diagram showing an example of an array of the red light converging region.
FIG. 7F is a diagram showing an example of a traveling direction of green light incident on a second green light converging region, and FIG. 7G is a diagram showing an example of an array of the second green light converging region.
FIGS. 8A and 8B are detailed plan views of size profiles of first nano-posts of a first lens layer and second nano-posts of a second lens layer in a color separation lens array provided in a pixel array of an image sensor according to an example embodiment, respectively.
FIG. 9 is a detailed plan view of a size profile of nano-posts provided in a color separation lens array according to a comparative example.
FIG. 10 is a cross-sectional view of a pixel array of an image sensor according to another example which does not fall within the scope of the claims.
FIG. 11 is a cross-sectional view of a pixel array of an image sensor according to another example which does not fall within the scope of the claims.
FIG. 12 is a cross-sectional view of a pixel array of an image sensor according to another embodiment.
FIGS. 13A to 13F are diagrams for describing a method of manufacturing an image sensor according to an example which does not fall within the scope of the claims.
FIGS. 14A to 14C are diagrams for describing a method of manufacturing an image sensor according to another example which does not fall within the scope of the claims.
FIGS. 15A to 15F are diagrams for describing a method of manufacturing an image sensor according to another embodiment.
FIG. 16 is a schematic block diagram of an electronic device including an image sensor according to example embodiments.
FIG. 17 is a block diagram schematically showing a camera module included in the electronic device of FIG. 16.

### DETAILED DESCRIPTION

Reference will now be made in detail to example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, example embodiments of the disclosure will be described in detail with reference to the accompanying drawings. Meanwhile, the example embodiments described below are merely examples, and, within the scope defined by the appended claims, various modifications are possible from these example embodiments. In the drawings, like reference numerals denote like elements, and the size and thickness of each element may be exaggerated for clarity of explanation.

Hereinafter, what is described as being "above" or "on" may include not only that which is directly above in contact, but also that which is above in a non-contact manner.

While such terms as "first" and "second" may be used to describe various components, but are used only for the purpose of distinguishing one component from other components. These terms do not limit materials or structures of components.

An expression used in the singular encompasses the expression of the plural, unless it has a clearly different meaning in the context. In addition, unless explicitly described to the contrary, the word "comprise" and variations such as "comprises" or "comprising" will be understood to imply the inclusion of stated elements but not the exclusion of any other elements.

In addition, the terms "unit", "-or", and "module" described in the specification mean units for processing at least one function and operation and may be implemented by hardware components or software components and combinations thereof.

The use of the terms "the" and similar indication words may refer to both singular and plural.

Operations that constitute a method may be performed in any suitable order, unless explicitly stated to be done in an order described. A method in accordance with the present invention must at least comprise the steps defined in appended claim 12. Furthermore, the use of all exemplary terms (e.g., etc.) is merely intended to be illustrative of technical ideas and is not to be construed as limiting the scope of the term unless further limited by the claims.

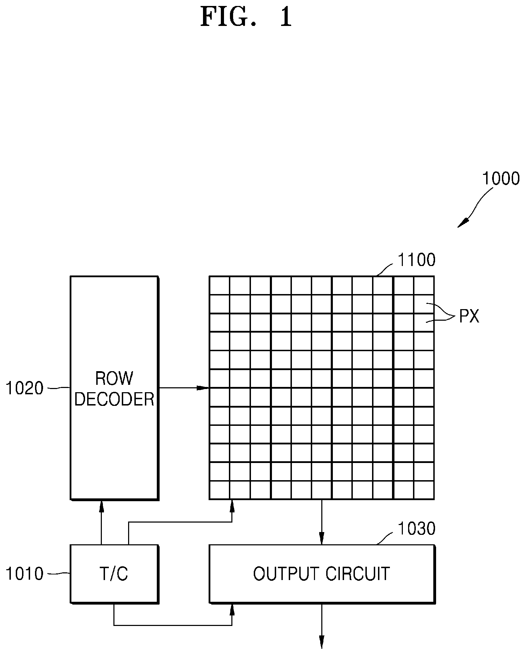

Referring to FIG. 1, an image sensor 1000 may include a pixel array 1100, a timing controller 1010, a row decoder 1020, and an output circuit 1030. The image sensor may be a charge coupled device (CCD) image sensor or a complementary metal oxide semiconductor (CMOS) image sensor.

The pixel array 1100 includes pixels that are 2-dimensionally arranged along a plurality of rows and a plurality of columns. The row decoder 1020 selects one row from among the plurality of rows of the pixel array 1100 in response to a row address signal output from the timing controller 1010. The output circuit 1030 outputs light detecting signals column by column from a plurality of pixels arranged along the selected row. To this end, the output circuit 1030 may include a column decoder and an analog to digital converter (ADC). For example, the output circuit 1030 may include a plurality of ADCs arranged for respective columns between the column decoder and the pixel array 1100 or one ADC provided at an output end of the column decoder. The timing controller 1010, the row decoder 1020, and the output circuit 1030 may be implemented as a single chip or may be implemented as separate chips. A processor for processing an image signal output through the output circuit 1030 may be implemented as a single chip together with the timing controller 1010, the row decoder 1020, and the output circuit 1030.

The pixel array 1100 may include a plurality of pixels for sensing light of different wavelengths. The arrangement of pixels may be implemented in various ways.

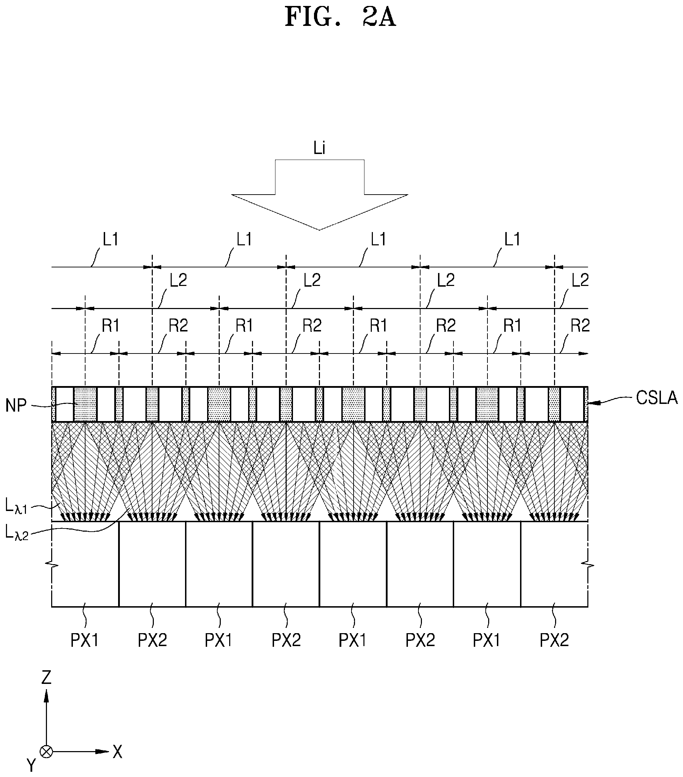

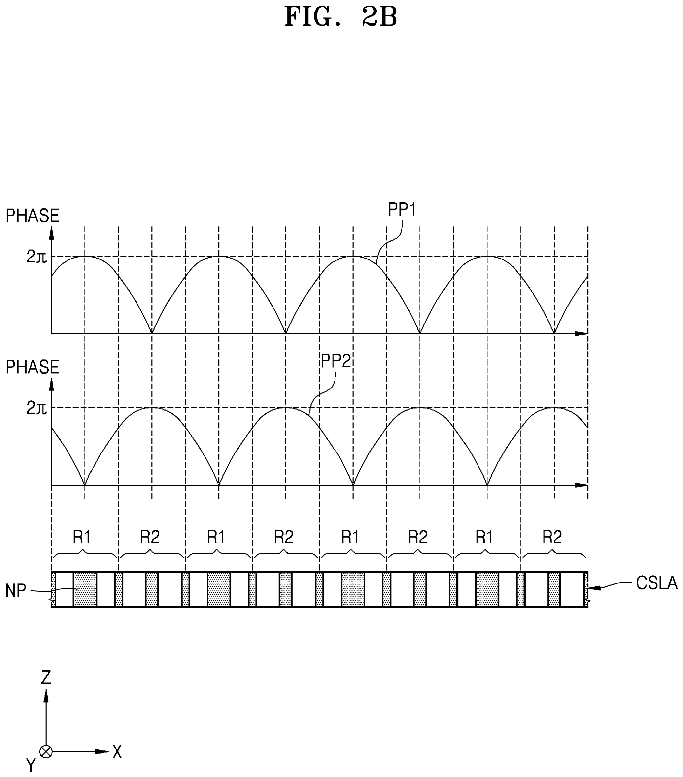

FIGS. 2A and 2B are conceptual views of a schematic structure and operation of a color separation lens array provided in an image sensor according to an example which does not fall within the scope of the claims.

Referring to FIG. 2A, a color separation lens array CSLA may include a plurality of nano-posts NP that change the phase of incident light Li differently according to incident positions. The color separation lens array CSLA may be divided in various ways. For example, the color separation lens array CSLA may be divided into a first pixel correspondence region R1 corresponding to a first pixel PX1 at which first wavelength light Lλ₁ included in the incident light Li is focused and a second pixel correspondence region R2 corresponding to a second pixel PX2 at which second wavelength light Lλ₂ included in the incident light Li is focused. The first pixel correspondence region R1 and the second pixel correspondence region R2 may each include one or more nano-posts NP and may be arranged to face the first pixel PX1 and the second pixel PX2, respectively. According to another example, the color separation lens array CSLA may include a first wavelength converging region L1 for converging the first wavelength light Lλ₁ to the first pixel PX1 and a second wavelength converging region L2 for converging the second wavelength light Lλ₂ to the second pixel PX2. The first wavelength converging region L1 and the second wavelength converging region L2 may partially overlap each other.

The color separation lens array CSLA may form different phase profiles in the first wavelength light Lλ₁ and the second wavelength light Lλ₂ included in the incident light Li, thereby converging the first wavelength light Lλ₁ to the first pixel PX1 and converging the second wavelength light Lλ₂ to the second pixel PX2.

For example, referring to FIG. 2B, the color separation lens array CSLA may cause the first wavelength light Lλ₁ to have a first phase profile PP1 and the second wavelength light Lλ₂ to have a second phase profile PP2 at positions immediately after passing through the color separation lens array CSLA, that is, positions on the bottom surface of the color separation lens array CSLA, and thus the first wavelength light Lλ₁ and the second wavelength light Lλ₂ may be converged at the first pixel PX1 and the second pixel PX2 corresponding thereto, respectively. In detail, the first wavelength light Lλ₁ passed through the color separation lens array CSLA may have a phase profile that is greatest at the center of the first pixel correspondence region R1 and decreases in a direction away from the center of the first pixel correspondence region R1, that is, a direction toward the second pixel correspondence region R2. The phase profile is similar to the phase profile of light converging to a point through a convex lens, e.g., a microlens having a convex center and provided in the first wavelength converging region L1, and the first wavelength light Lλ₁ may be converged to the first pixel PX1. Also, the second wavelength light Lλ₂ passed through the color separation lens array CSLA may have a phase profile that is greatest at the center of the second pixel correspondence region R2 and decreases in a direction away from the center of the second pixel correspondence region R2, that is, a direction toward the first pixel correspondence region R1, and thus the second wavelength light Lλ₂ may be converged to the second pixel PX2.

Since the refractive index of a material varies according to the wavelength of reacting light, the color separation lens array CSLA may provide different phase profiles for the first wavelength light Lλ₁ and the second wavelength light Lλ₂. In other words, since even the same material exhibits different refractive indexes for different wavelengths of light incident thereon, and different wavelengths of light have different phase delays after passing through the same material, different phase profiles may be formed for different wavelengths. For example, since the refractive index of the first pixel correspondence region R1 with respect to the first wavelength light Lλ₁ and the refractive index of the first pixel correspondence region R1 with respect to the second wavelength light L_{λ2} may be different from each other and the phase delay of the first wavelength light Lλ₁ passed through the first pixel correspondence region R1 and the phase delay of the second wavelength light Lλ₂ passed through the first pixel correspondence region R1 may be different from each other, by designing the color separation lens array CSLA in consideration of the properties of light, different phase profiles may be provided to the first wavelength light Lλ₁ and the second wavelength light Lλ₂, respectively.

The color separation lens array CSLA may include nano-posts NP arranged according to a particular rule, such that the first wavelength light Lλ₁ and the second wavelength light Lλ₂ have the first phase profile PP1 and the second phase profile PP2, respectively. Here, the rule is applied to parameters, such as the shape, the size (width and height), the spacing, and the arrangement shape of the nano-posts NP, and the parameters may be determined based on a target phase profile to be implemented through the color separation lens array CSLA.

A rule for arranging the nano-posts NP in the first pixel correspondence region R1 and a rule for arranging the nano-posts NP in the second pixel correspondence region R2 may be different from each other. In other words, the size, shape, spacing, and/or arrangement of the nano-posts NP provided in the first pixel correspondence region R1 may be different from the size, shape, spacing, and/or arrangement of the nano-posts NP provided in the second pixel correspondence region R2.

The nano-posts NP may have a shape dimension in the sub-wavelength. Here, the sub-wavelength means a wavelength less than a wavelength band of light to split. The nano-posts NP may have, for example, a shape dimension less than a shorter one of a first wavelength and a second wavelength. The nano-posts NP may have a cylindrical shape having a sub-wavelength cross-sectional diameter. However, the shape of the nano-posts NP is not limited thereto. When the incident light Li is a visible ray, the diameter of the cross-section of the nano-posts NP may have a dimension less than, for example, 400 nm, 300 nm, or 200 nm. On the other hand, the height of the nano-posts NP may be from about 500 nm to about 1500 nm, wherein the height may be greater than the diameter of the cross-section. According to an example, the nano-post NP may include a combination of two or more posts stacked in the height-wise direction (Z direction).

The nano-posts NP may include a material having a higher refractive index than that of a surrounding material. The nano-posts NP may include, for example, c-Si, p-Si, a-Si, a group III-V compound semiconductor (e.g., GaP, GaN, GaAs, etc.), SiC, TiO₂, SiN, and/or a combination thereof. The nano-posts NPs having a refractive index different from that of a surrounding material may change the phase of light passing through the nano-posts NP. This is due to a phase delay caused by sub-wavelength shape dimension of the nano-posts NPs, and the degree of the phase delay is determined based on the specific shape dimension and arrangement and the like of the nano-posts NPs. The surrounding material of the nano-posts NP may include a dielectric material having a lower refractive index than that of the nano-posts NP. For example, the surrounding material may include SiO₂ or the air. However, it is merely an example, and the material constituting the nano-posts NP and the surrounding material may be selected, such that the nano-posts NP have a lower refractive index than that of the surrounding material.

The region division of the color separation lens array CSLA and the shape and the arrangement of the nano-posts NPs may be set to form a phase profile that separates incident light according to wavelengths to be converged to a plurality of pixels, that is, the first pixel PX1 and the second pixel PX2. The wavelength separation may include, but is not limited to, color separation in a visible light band, and the wavelength band may be extended to a range of visible light to infrared light or various other ranges. A first wavelength λ₁ and a second wavelength λ₂ may be from visible light wavelength band to infrared light wavelength band. However, the disclosure is not limited thereto, and the first wavelength λ₁ and the second wavelength λ₂ may include various wavelength bands according to arrangement rules of the plurality of nano-posts NP. Also, although a case where incident light is split into light beams of two wavelengths and converged is shown, the disclosure is not limited thereto, and incident light may be split into three or more directions according to wavelengths and converged.

Also, the color separation lens array CSLA has been described based on an example in which the nano-posts NP are arranged in a single layer, but the color separation lens array CSLA may also have a stacked structure in which the nano-posts NP are arranged in a plurality of layers.

On the other hand, as described above, the wavelength separation by the color separation lens array CSLA is based on the refractive index profile due to the shape and the material of the nano-posts NP and the surrounding material. When parameters for forming a desired refractive index profile are not well implemented, wavelength separation efficiency may be lowered. Since am image sensor according to an example is manufactured according to a manufacturing method capable of reducing process dispersion during a manufacturing process, color separation efficiency may be maximized.

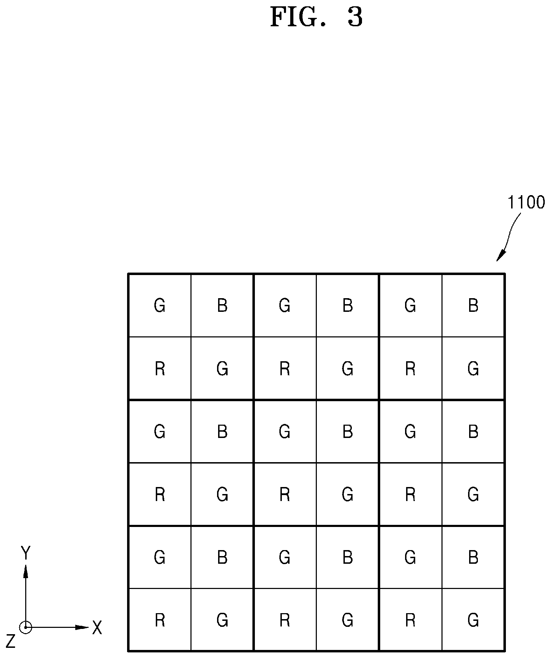

FIG. 3 is a plan view of a color arrangement indicated by a pixel array of an image sensor according to an example embodiment.

The pixel arrangement shown in FIG. 3 is a Bayer pattern arrangement generally employed in the image sensor 1000. As shown in FIG. 3, one unit pattern includes four quadrant regions, and first to fourth quadrants may become a blue pixel B, a green pixel G, a red pixel R, and a green pixel G, respectively. Such unit patterns may be 2-dimensionally and repeatedly arranged in a first direction (X direction) and a second direction (Y direction). In other words, in a unit pattern in the form of a 2x2 array, two green pixels G are arranged in one diagonal direction, and one blue pixel B and one red pixel R are arranged in the other diagonal direction. In terms of the overall pixel arrangement, first rows in which a plurality of green pixels G and a plurality of blue pixels B are alternately arranged in the first direction and second rows in which a plurality of red pixels R and a plurality of green pixels G are alternately arranged in the first direction are repeatedly arranged in the second direction.

The pixel array 1100 of the image sensor 1000 may include a color separation lens array for converging light of a color corresponding to a specific pixel in correspondence to such a color arrangement. In other words, region division and shape and arrangements of the nano-posts NP may be set for wavelengths separated by the color separation lens array CSLA described with reference to FIGS. 2A and 2B, such that the wavelengths become a red wavelength, a green wavelength, and a blue wavelength, respectively.

The color arrangement of FIG. 3 is merely an example, and the disclosure is not limited thereto. For example, a CYGM arrangement in which a magenta pixel M, a cyan pixel C, a yellow pixel Y, and a green pixel G constitute one unit pattern or an RGBW arrangement in which a green pixel G, a red pixel R, a blue pixel B, and a white pixel W constitute one unit pattern may be used. Also, a unit pattern may be implemented in the form of a 3×2 array. Furthermore, pixels of the pixel array 1100 may be arranged in various ways according to color characteristics of the image sensor 1000. Hereinafter, an example in which the pixel array 1100 of the image sensor 1000 has a Bayer pattern will be described, but the principle of operation may be applied to a pixel array in a form other than the Bayer pattern.

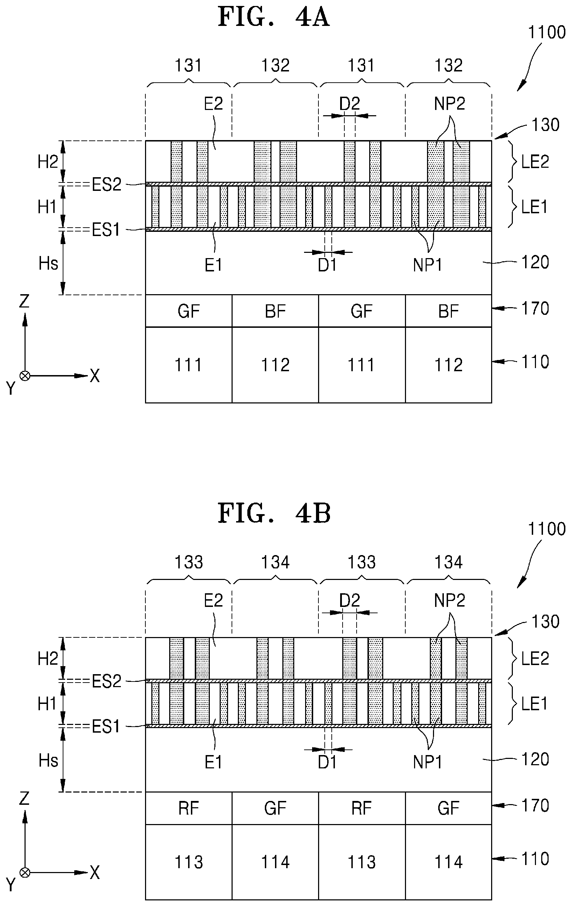

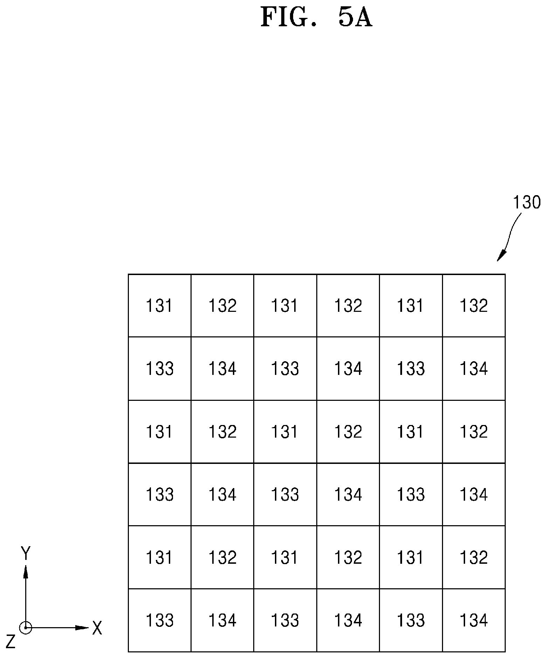

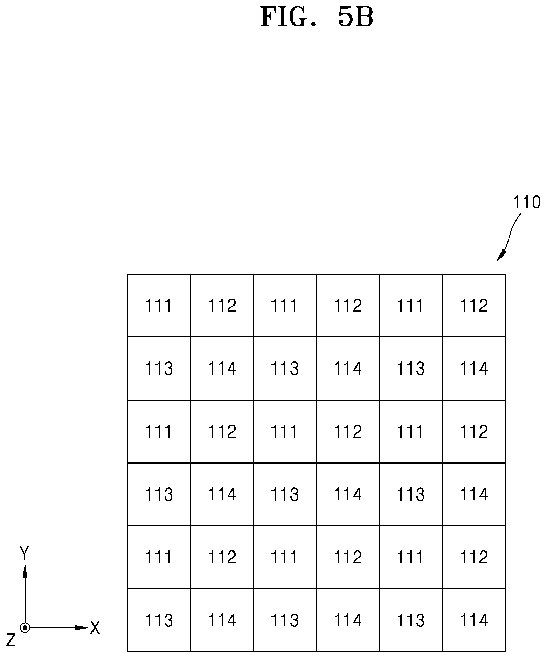

FIGS. 4A and 4B are cross-sectional views of the pixel array 1100 of the image sensor of FIG. 1 viewed from different cross-sections, respectively. FIG. 5A is a plan view of the arrangement of a pixel corresponding region of the color separation lens array 130 provided in the pixel array 1100, and FIG. 5B is a plan view of a pixel arrangement of a sensor substrate 110 provided in the pixel array 1100.

Referring to FIGS. 4A and 4B, the pixel array 1100 of the image sensor 1000 includes a sensor substrate 110, which includes a plurality of pixels 111, 112, 113, and 114 sensing light, and a color separation lens array 130 provided on the sensor substrate 110.

A spacer layer 120 is provided between the sensor substrate 110 and the color separation lens array 130. The spacer layer 120 is a transparent spacer layer. The spacer layer 120 supports the color separation lens array 130 and may have a thickness Hs that satisfies a distance requirement between the sensor substrate 110 and the color separation lens array 130.

A color filter array 170 may be provided between the sensor substrate 110 and the spacer layer 120. The color filter array 170 may include a red filter RF, a green filter GF, and a blue filter BF and may be arranged in a shape corresponding to the color arrangement as shown in FIG. 3. In an example embodiment, the color separation lens array 130 performs color separation, and the additionally provided color filter array 170 may improve color purity by compensating for some errors that may appear during color separation by the color separation lens array 130. According to another example embodiment, the color filter array 170 may be omitted.

The color separation lens array 130 has a form in which a plurality of nano-posts are arranged in a plurality of layers. The plurality of nano-posts have various widths according to arrangement positions, and nano-posts having widths less than a reference size are arranged only in one of the plurality of layers. According to an example embodiment, the reference size is a predetermined reference size. The predetermined reference size will be hereinafter referred to as a reference size wc. The reference size wc may be set in consideration of the performance of photolithography equipment used in a process of manufacturing the color separation lens array 130, e.g., a minimum critical dimension CD that may be implemented by the photolithography equipment. The reference size wc is equal to or greater than 80 nm and less than or equal to 200 nm. Since the reference size wc is determined in consideration of the performance of photolithography equipment. For example, the reference size wc may be determined within the range from about 80 nm to about 100 nm or may be determined within the range from about 170 nm to about 200 nm, but is not limited to the above-stated ranges. According to the invention, as defined in appended claim 1, the reference width is greater than or equal to 80 nm and less than or equal to 200 nm.

According to an example embodiment, in the descriptions below, a first layer LE1 in which nano-posts having widths less than the reference size wc and nano-posts having widths equal to or greater than the reference size wc are arranged together will be referred to as a narrow-CD layer, and a second layer LE2 in which only nano-posts having widths greater than the reference size wc are arranged will be referred to as a wide-CD layer. Also, along with the terms the narrow-CD layer and the wide-CD layer, the terms including a first lens layer LE1 and a second lens layer LE2 may be used together according to an arrangement order from the spacer layer 120.

The color separation lens array 130 includes the first lens layer LE1 including a plurality of first nano-posts NP1 and the second lens layer LE2 including a plurality of second nano-posts NP2, wherein the first lens layer LE1 may be a narrow-CD layer and the second lens layer LE2 may be a wide-CD layer.

According to an example embodiment, the plurality of first nano-posts NP1 may have a width D1, where the width D1 corresponds to a width of a cross-section perpendicular to the height-wise direction (Z direction). According to an example embodiment, the width D1 may be a sub-wavelength value. According to an example embodiment, the width D1 may be less than the wavelength of light separated by the color separation lens array 130. According to an example embodiment, the width D1 may be less than the center wavelength of the wavelength band of light separated by the color separation lens array 130. According to an example embodiment, the width D1 may also be less than half the center wavelength of the wavelength band of light separated by the color separation lens array 130. According to an example embodiment, the plurality of the first nano-posts may have different widths D1. For example, a range of the width D1 may be a range including all values less than and greater than the reference size wc. For example, one or more of the plurality of first nano-posts may have a width D1 less than the reference size wc and other of the plurality of first nano-posts may have a width D1 greater than the reference size wc. The upper limit of D1 may be, for example, 400 nm, 350 nm, or 250 nm. The lower limit of D1 may be 50 nm, 60 nm, or 70 nm.

According to an example embodiment, the plurality of second nano-posts NP2 may have a width D2, where the width D2 corresponds to a width of a cross-section perpendicular to the height-wise direction (Z direction). According to an example embodiment, the width D2 of a second nano-post NP2, may be a sub-wavelength value. According to an example embodiment, the plurality of the first nano-posts may have different widths D1. For example, a range of width D2, may have an upper limit of 400 nm, 300 nm, or 250 nm, similar to that of D1. However, unlike the width D1, the lower limit of the range of the width D2 may be greater than the reference size wc.

The first nano-posts NP1 and the second nano-posts NP2 may have post-like shapes having heights H1 and H2 in the Z direction, respectively, may have cylindrical shapes, elliptical column-like shapes, or polygonal column-like shape, or may have post-like shapes having symmetrical or asymmetrical cross-sectional shapes. Although the first nano-post NP1 and the second nano-post NP2 having constant widths perpendicular to the height-wise direction (i.e., rectangular cross-sections parallel to the height-wise direction) are shown, it is merely an example. Unlike as shown in the drawings, the widths of the first nano-posts NP1 and the second nano-posts NP2 perpendicular to the height-wise direction may not be constant. For example, the shape of cross-sections thereof parallel to the height-wise direction may have an inverted trapezoidal shape. When the widths of the first nano-posts NP1 and the second nano-posts NP2 perpendicular to the height-wise direction are not constant, the above-stated D1 and D2 may be defined as the largest values in a non-uniform width range.

The heights H1 and H2 of the first nano-posts NP1 and the second nano-posts NP2 may be from sub-wavelength sizes to sizes several times greater than a wavelength. For example, the heights H1 and H2 of the first nano-post NP1 and the second nano-post NP2 may be 5 times or less, 4 times or less, or 3 times or less than the central wavelength of the wavelength band of light separated by the color separation lens array 130. The heights H1 and H2 of the first nano-posts NP1 and the second nano-posts NP2 may each be, for example, from about 200 nm to about 1500 nm. However, it is merely an example, and the disclosure is not limited thereto. The range of the sum of the height H1 of the first nano-post NP1 and the height H2 of the second nano-post NP2 (i.e., H1+H2) may be from about 800 nm to about 1500 nm or from about 800 nm to about 1000 nm. The height H1 of the first nano-post NP1 and the height H2 of the second nano-post NP2 may be identical to or different from each other. The heights H1 and H2 may be determined to be appropriate for forming a phase profile for color separation, which will be described later, and may also be determined in consideration of detailed process conditions, which will be described later.

The first lens layer LE1 includes the plurality of first nano-posts NP1 and a first surrounding material layer E1 provided around them, and the second lens layer LE2 includes the plurality of second nano-posts NP2 and a second surrounding material layer E2 provided around them. The first surrounding material layer E1 may be provided in the form surrounding the side surfaces of the first nano-posts NP1, and the second surrounding material layer E2 may be provided in the form surrounding the side surfaces of the second nano-posts NP2. The first nano-post NP1 may include a material having a higher refractive index than the first surrounding material layer E1, and the second nano-post NP2 may include a material having a higher refractive index than the second surrounding material layer E2. However, it is merely an example, and the refractive index relationship may be reversed.

According to an example embodiment, a material having a high refractive index may include at least one of c-Si, p-Si, a-Si, a group III-V compound semiconductor (GaAs, GaP, GaN, GaAs, etc.), SiC, TiO₂, and SiN, whereas a material having a low refractive index may include a polymer material like SU-8 and PMMA, SiO₂, SOG, or the air.

The first nano-post NP1 and the second nano-post NP2 may include the same material. The first surrounding material layer E1 and the second surrounding material layer E2 may include the same material. However, the disclosure is not limited thereto.

According to the invention, a first etch stop layer ES1 is provided between the spacer layer 120 and the first lens layer LE1. The first etch stop layer ES1 may be provided to protect the spacer layer 120, which is a structure below the color separation lens array 130, in a process of manufacturing the color separation lens array 130. During fabrication of the first lens layer LE1 on the spacer layer 120, after a material layer to be patterned as the first surrounding material layer E1 is deposited, a process of etching the material layer to a predetermined depth is performed to form holes to be filled with a material to become the first nano-posts NP1. At this time, the spacer layer 120 may be damaged due to etching beyond a desired depth, and, when the thickness Hs of the spacer layer 120 does not satisfy the distance requirement between the color separation lens array 130 and the sensor substrate 110, color separation performance may be deteriorated. The first etch stop layer ES1 may include a material having an etch selectivity lower than that of the material layer to be etched, and thus the first etch stop layer ES1 remains without being easily removed during an etching process. Therefore, the first etch stop layer ES1 may prevent the spacer layer 120 from being damaged by the etching process. The first etch stop layer ES1 may include HfO₂. The thickness of the first etch stop layer ES1 may be determined in consideration of an etching depth, that is, a height H1 of the first lens layer LE1, and may also be determined in consideration of the etch distribution within a process wafer. The thickness of the first etch stop layer ES1 may be from about 3 nm to about 30 nm.

According to an example embodiment, a second etch stop layer ES2 may be provided between the first lens layer LE1 and the second lens layer LE2. The second etch stop layer ES2 may be provided to prevent the first lens layer LE1 from being damaged in a process of fabricating the second lens layer LE2. During fabrication of the second lens layer LE2 on the first lens layer LE1, after a material layer to be patterned as the second surrounding material layer E2 is deposited, a process of etching the material layer to a predetermined depth is performed to form holes to be filled with a material to become the second nano-posts NP2. At this time, the first lens layer LE1 may be damaged due to etching beyond a desired depth, and, when the height H1 of the first lens layer LE1 does not satisfy a desired height requirement, color separation performance may be deteriorated. The second etch stop layer ES2 formed on the first lens layer LE1 may include a material having an etch selectivity lower than that of the material layer to be etched, and thus the second etch stop layer ES2 remains without being easily removed during an etching process. Therefore, the second etch stop layer ES2 may prevent the first lens layer LE1 from being damaged by the etching process. The second etch stop layer ES2 may include HfO₂. The thickness of the second etch stop layer ES2 may be determined in consideration of an etching depth, that is, a height H2 of the second lens layer LE2, and may also be determined in consideration of the etch distribution within a process wafer. The thickness of the second etch stop layer ES2 may be from about 3 nm to about 30 nm.

According to an example embodiment, a protective layer for protecting the color separation lens array 130 may be further provided on the color separation lens array 130. The protective layer may include a material serving as an anti-reflection layer. An anti-reflection layer may reduce light reflected by the top surface of the color separation lens array 130 from incident light, thereby improving light utilization efficiency of the pixel array 1100. In other words, the anti-reflection layer allows light incident from the outside on the pixel array 1100 to pass through the color separation lens array 130 without being reflected by the top surface of the color separation lens array 130 to be detected by the sensor substrate 110. The anti-reflection layer may have a structure in which one or a plurality of layers are stacked. For example, the anti-reflective layer may include one layer including a material different from the material constituting the second lens layer LE2, or a plurality of material layers having different refractive indices from one another.

The sensor substrate 110 includes a plurality of light sensing cells that detect light and convert detected light into electrical signals. The plurality of photo-sensing cells may include first green pixels 111, blue pixels 112, red pixels 113, and second green pixels 114. As shown in FIGS. 4A, 4B, and 5B, the first green pixels 111 and the blue pixels 112 may be alternately arranged in the first direction (X-direction), and, in a cross-section having different positions in the Y-direction, the red pixels 113 and the second green pixels 114 may be alternately arranged.

The pixel arrangement of the sensor substrate 110 shown in FIG. 5B is an arrangement of pixels corresponding to the color arrangement of the Bayer pattern shown in FIG. 3. Hereinafter, the pixel arrangement of an image sensor may be used interchangeably with the pixel arrangement of a sensor substrate as the synonym. The pixel arrangement of the sensor substrate 110 is for sensing and dividing incident light into unit patterns like a Bayer pattern. For example, first green pixel 111 and the second green pixel 114 may sense green light, the blue pixel 112 may sense blue light, and the red pixel 113 may sense red light. According to an example embodiment, a separation film for separating cells may be further formed at the boundaries between cells.

Referring to FIGS. 4A, 4B, 5A and 5B, the color separation lens array 130 may be divided into four pixel correspondence regions 131, 132, 133, and 134 respectively corresponding to pixels 111, 112, 113, and 114 of the sensor substrate 110. A first green pixel correspondence region 131 corresponds to the first green pixel 111 and may be provided on the first green pixel 111. A blue pixel correspondence region 132 corresponds to the blue pixel 112 and may be provided on the blue pixel 112. A red pixel correspondence region 133 corresponds to the red pixel 113 and may be provided on the red pixel 111. A second green pixel correspondence region 134 corresponds to the second green pixel 114 and may be provided on the second green pixel 114. In other words, the pixel corresponding regions 131, 132, 133, and 134 of the color separation lens array 130 may be arranged to face the pixels 111, 112, 113, and 114 of the sensor substrate 110, respectively. The pixel correspondence regions 131, 132, 133, and 134 may be 2-dimensionally arranged in the first direction (X direction) and the second direction (Y direction), such that first rows, in which first green pixel correspondence regions 131 and blue pixel correspondence regions 132 are alternately arranged, and second rows, in which red pixel correspondence regions 133 and second green pixel correspondence regions 134 are alternately arranged, are alternately arranged. The color separation lens array 130 also includes a plurality of 2-dimensionally arranged unit patterns like the sensor substrate 110, and each unit pattern includes the pixel corresponding regions 131, 132, 133, and 134 arranged in a 2x2shape.

On the other hand, similarly as the concept described in FIG. 2A, it may be described that regions of the color separation lens array 130 include a green light converging region for converging green light, a blue light converging region for converging blue light, and a red light converging region for converging red light.

The color separation lens array 130 may include first nano-posts NP1 and the second nano-posts NP2 having sizes, shapes, spacing, and/or arrangements that are determined to separate and converge green light to first green pixel 111 and the second green pixel 114, light converging region for converging blue light to the blue pixel 112, and light converging region for converging red light to the red pixel 113.

In the plan view of FIG. 5A, nano-posts may be arranged in various shapes and arrangements in each of the pixel correspondence regions 131, 132, 133, and 134. The shapes and the arrangements of the nano-posts shown in the cross-sectional views of FIGS. 4A and 4B are also examples and are not limited thereto. Although FIGS. 4A and 4B show that one first nano-post NP1 and one second nano-post NP2 are provided in each region, it is merely an example. The number of the first nano-posts NP1 and the number of the second nano-posts NP2 provided in each region may be different from each other, and, at some positions, there may be no second nano-posts NP2 corresponding to the first nano-posts NP1. The first nano-posts NP1 and the second nano-posts NP2 may be arranged at boundaries between regions.

The pixel arrangement characteristic of the Bayer pattern may be reflected in the arrangement of nano-posts in the pixel correspondence regions 131, 132, 133, and 134. In a Bayer pattern pixel array, pixels adjacent to both the blue pixel 112 and the red pixel 113 in the first direction (X direction) and the second direction (Y direction) are the first and second green pixels 111 and 114. However, the pixel adjacent to the first green pixel 111 in the first direction (X direction) is the blue pixel 112, and the pixel adjacent to the first green pixel 111 in the second direction (Y direction) is the red pixel 113. Also, the pixel adjacent to the second green pixel 114 in the first direction (X direction) is the red pixel 113, and the pixel adjacent to the second green pixel 114 in the second direction (Y direction) is the blue pixel 112. Furthermore, pixels adjacent to both the first green pixel 111 and the second green pixel 114 in four diagonal directions are green pixels, pixels adjacent to the blue pixel 112 in four diagonal directions are all red pixels 113, and pixels adjacent to the red pixel 113 in four diagonal directions are all blue pixels 112. Therefore, the first nano-posts NP1 may be arranged in a 4-fold symmetrical shape in the blue pixel correspondence region 132 and the red pixel correspondence region 133 respectively corresponding to the blue pixel 112 and the red pixel 113, and the first nano-posts NP1 may be arranged in a 2-fold symmetrical shape in the first green pixel correspondence region 131 and the second green pixel correspondence region 134. The first nano-posts NP1 in the first green pixel correspondence region 131 and the second green pixel correspondence region 134 may have asymmetric cross-sectional shapes having different widths in the first direction (X direction) and the second direction (Y direction), and the first nano-posts NP1 in the blue pixel correspondence region 132 and the red pixel correspondence region 133 may have symmetrical cross-sectional shape having the same widths in the first direction (X direction) and the second direction (Y direction). The arrangements of the first nano-posts NP1 in the first green pixel correspondence region 131 and the second green pixel correspondence region 134 may have shapes rotated by 90 degrees with respect to each other.

The arrangement rule of the first nano-post NP1 and the second nano-post NP2 is an example for wavelength separation corresponding to a pixel arrangement and is not limited to the above descriptions or the pattern shown in the drawing.

The spacer layer 120 is provided between the sensor substrate 110 and the color separation lens array 130 to maintain a constant distance between the sensor substrate 110 and the color separation lens array 130. The spacer layer 120 may include a material transparent to visible light, that is, a dielectric material having a refractive index lower than that of the nano-posts NP and exhibiting low absorption in the visible ray band, e.g., SiO2 and siloxane-based spin on glass (SOG). The thickness Hs of the spacer layer 120 may be selected within the range of ht - p ≤ Hs ≤ ht + p. Here, ht denotes the focal length of light having the center wavelength of a wavelength band separated by the color separation lens array 130, and p denotes a pixel pitch. In an example embodiment, the pixel pitch may be several µm or less, e.g., 2 µm or less, 1.5 µm or less, 1 µm or less, or 0.7 µm or less. The pixel pitch may be within the range from about 0.5 µm to about 1.5 µm. The thickness of the spacer layer 120 may be designed based on, for example, 540 nm, which is the center wavelength of green light.

The color filter array 170 may be provided between the sensor substrate 110 and the color separation lens array 130. In this case, in consideration of the thickness of the color filter array 170, the thickness of the spacer layer 120 may be set to be less than the focal length of light of the center wavelength of a wavelength band separated by the color separation lens array 130, by the color separation lens array 130. For example, the thickness may be set to be less than the focal length of green light by the color separation lens array 130.

The spacer layer 120 may also support first and second nano-posts NP1 and NP2 constituting the color separation lens array 130. The spacer layer 120 may include a dielectric material having a refractive index less than that of the first nano-posts NP1. When the first surrounding material layer E1 include a material having a higher refractive index than the first nano-posts NP1, the spacer layer 120 may include a material having a lower refractive index than the first surrounding material layer E1.

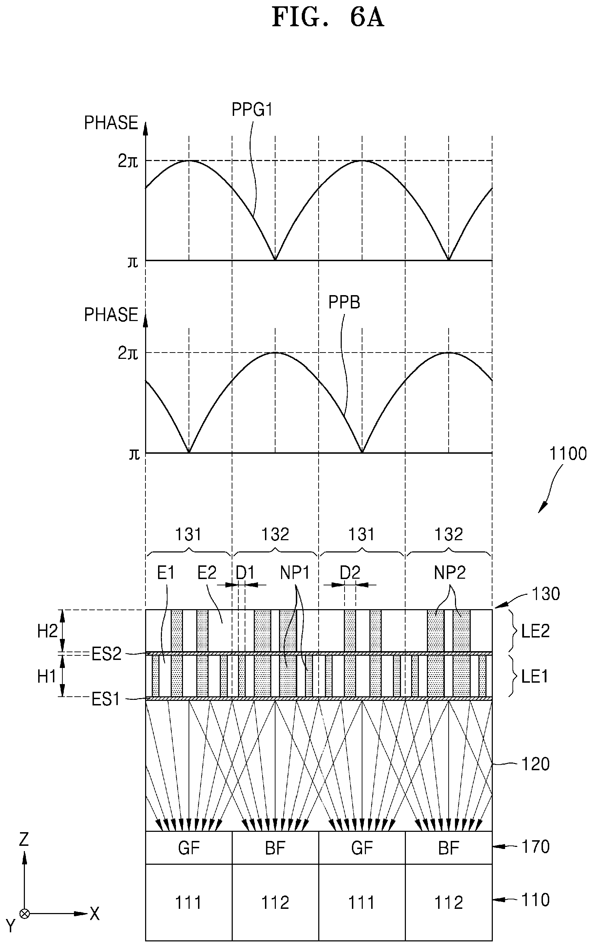

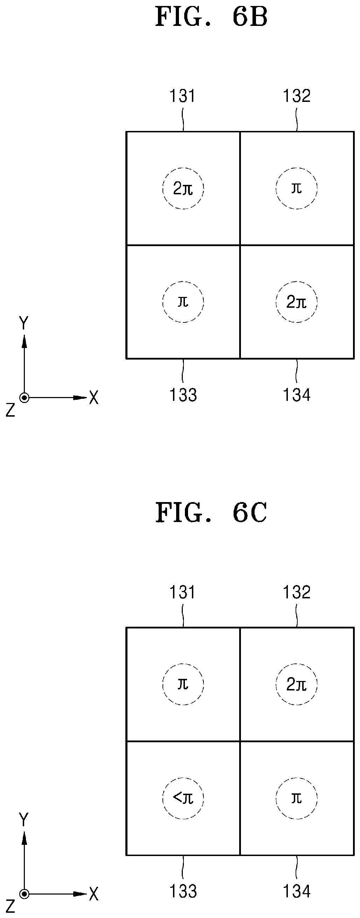

FIG. 6A shows phase profiles of green light and blue light passed through the color separation lens array 130 in the cross section of FIG. 4A, FIG. 6B shows phase of green light passed through the color separation lens array 130 at centers of the pixel corresponding regions 131, 132, 133, and 134, and FIG. 6C shows phase of blue light passed through the color separation lens array 130 at centers of the pixel corresponding regions 131, 132, 133, and 134. The phase profiles of the green light and the blue light of FIG. 6A are similar to the phase profiles of the first wavelength light and the second wavelength light described above with reference to FIG. 2B.

Referring to FIGS. 6A and 6B, green light passed through the color separation lens array 130 may have a first green light phase profile PPG1 that is the greatest at the center of the first green pixel correspondence region 131 and decreases in a direction away from the center of the first green pixel correspondence region 131. In detail, at a position immediately after passing through the color separation lens array 130, that is, on the bottom surface of the color separation lens array 130 or the top surface of the spacer layer 120, the phase of green light is the greatest at the center of the first green pixel correspondence region 131, gradually decreases in the form of concentric circles in directions away from the center of the first green pixel correspondence region 131, becomes the smallest at centers of the blue pixel correspondence region 132 and the red pixel correspondence region 133 in the X direction and the Y direction, and becomes the smallest at a contact point between the first green pixel correspondence region 131 and the second green pixel correspondence region 134 in diagonal directions. When the phase of green light emitted from the center of the first green pixel correspondence region 131 is set as 2 π, light of the phase from about 0.9 π to about 1.1 π may be emitted from centers of the blue pixel correspondence region 132 and the red pixel correspondence region 133, light of the phase of 2 π may be emitted from the center of the second green pixel correspondence region 134, and light of the phase from about 1.1 π to about 1.5 π may be emitted from the contact point between the first green pixel correspondence region 131 and the second green pixel correspondence region 134. Therefore, the phase difference between green light passed through the center of the first green pixel correspondence region 131 and green light passed through the centers of the blue pixel correspondence region 132 and the red pixel correspondence region 133 may be from about 0.9 π to about 1.1 π.

Meanwhile, the first green light phase profile PPG1 does not mean that the phase delay of light passed through the center of the first green pixel correspondence region 131 is the greatest. When the phase of the light passed through the first green pixel correspondence region 131 is set as 2π and the phase delay of light passed through another position is greater and has a phase value greater than 2π, the first green light phase profile PPG1 may be a profile of a value remaining after removing 2 nπ, that is, a wrapped phase. For example, when the phase of light passed through the first green pixel correspondence region 131 is 2π and the phase of light passed through the center of the blue pixel correspondence region 132 is 3π, the phase of light in the blue pixel correspondence region 132 may be π, which is a result of removing 2π from 3π (when n=1).

Referring to FIGS. 6A and 6C, blue light passed through the color separation lens array 130 may have a blue light phase profile PPB that is greatest at the center of the blue pixel correspondence region 132 and decreases in a direction away from the center of the blue pixel correspondence region 132. In detail, the phase of blue light at a position immediately after passing through the color separation lens array 130 is greatest at the center of the blue pixel correspondence region 132, gradually decreases in the form of concentric circles in directions away from the center of the blue pixel correspondence region 132, becomes the smallest at centers of the first green pixel correspondence region 131 and the second green pixel correspondence region 134 in the X direction and the Y direction, and becomes the smallest at the center of the red pixel correspondence region 133 in diagonal directions. When the phase of blue light at the center of the blue pixel correspondence region 132 is 2 π, the phase of the blue light at the centers of the first green pixel correspondence region 131 and the second green pixel correspondence region 134 may be, for example, from about 0.9 π to about 1.1 π, and the phase of the blue light at the red pixel correspondence region 133 may be less than the phases at the centers of the first green pixel correspondence region 131 and the second green pixel correspondence region 134, e.g., from about 0.5 π to about 0.9 π.

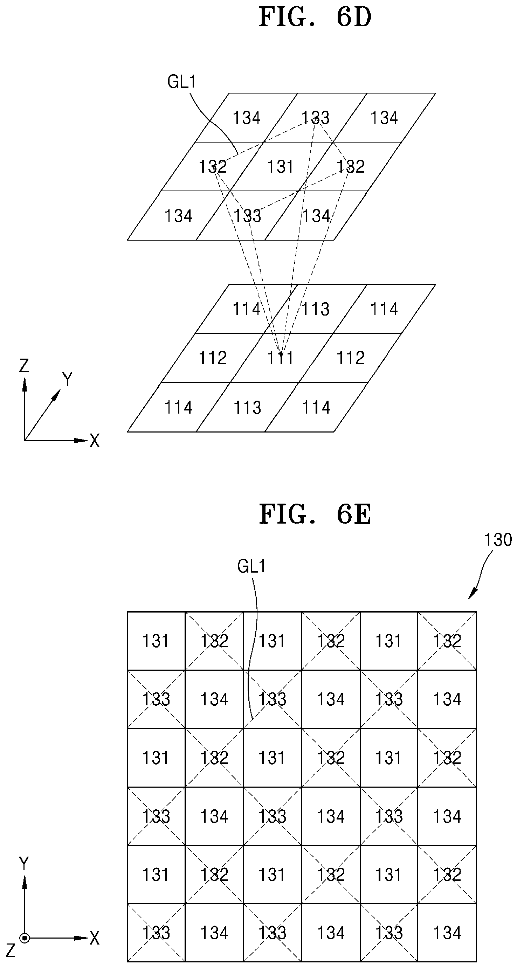

FIG. 6D is a diagram showing an example of a traveling direction of green light incident on a first green light converging region, and FIG. 6E is a diagram showing an example of an array of the first green light converging region.

As shown in FIG. 6D, the green light incident around the first green pixel correspondence region 131 is converged to the first green pixel 111 by the color separation lens array 130, and not only green light from the first green pixel correspondence region 131, but also green light from the blue pixel correspondence region 132 and the red pixel correspondence region 133 is incident on the first green pixel 111. In other words, the phase profile of green light described with reference to FIGS. 6A and 6B converges green light passed through a first green light converging region GL1, which connects centers of two blue pixel correspondence regions 132 and two red pixel correspondence regions 133 that are each adjacent to one side of the first green pixel correspondence region 131, to the first green pixel 111. Therefore, as shown in FIG. 6E, the color separation lens array 130 may operate as an array of the first green light converging region GL1 for converging green light to the first green pixel 111. The first green light converging region GL1 is larger than a corresponding first green pixel 111 and may be, for example, from 1.2 times to 2 times larger than the corresponding first green pixel 111.

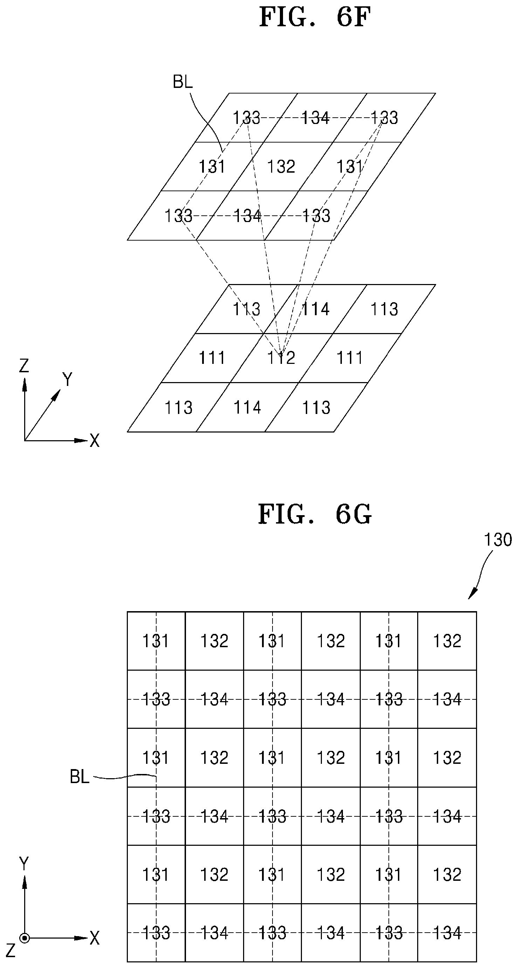

FIG. 6F is a diagram showing an example of a traveling direction of blue light incident on a blue light converging region, and FIG. 6G is a diagram showing an example of an array of the blue light converging region.

Blue light is converged to the blue pixel 112 by the color separation lens array 130 as shown in FIG. 6F, and blue light from the pixel correspondence regions 131, 132, 133, and 134 is incident to the blue pixel 112. The phase profile of blue light described in FIGS. 6A and 6C converges blue light passed through a blue light converging region BL, which is formed by connecting centers of four red pixel correspondence regions 133 adjacent to four vertices of the blue pixel correspondence region 132, to the blue pixel 112. Accordingly, as shown in FIG. 6G, the color separation lens array 130 may operate as an array of the blue light converging region BL for converging blue light to the blue pixel 112. The blue light converging region BL is larger than a corresponding blue pixel 112 and may be, for example, from 1.5 times to 4 times larger than the corresponding blue pixel 112. The blue light converging region BL may partially overlap the above-stated first green light converging region GL1 and a second green light converging region GL2 and a red light converging region RL which will be described later.

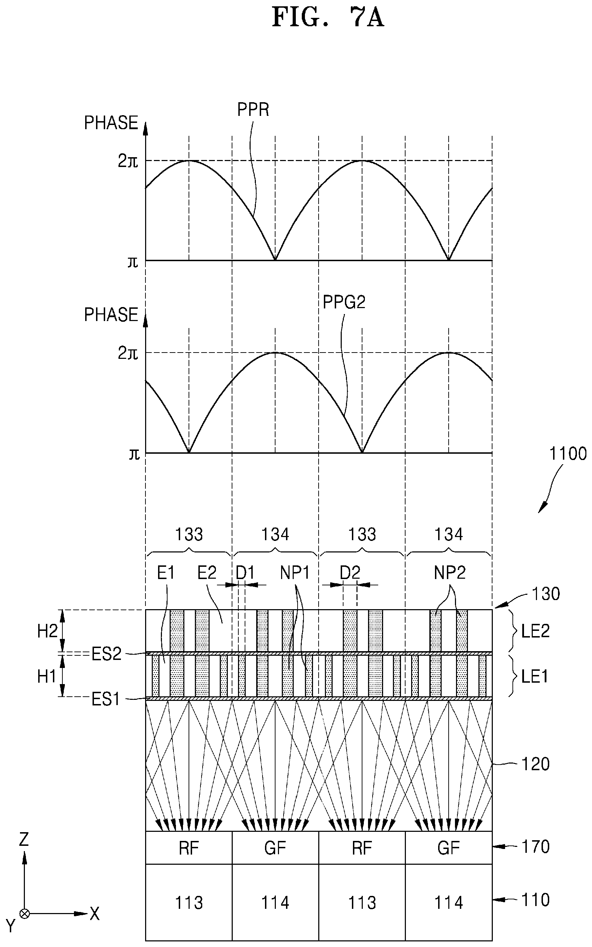

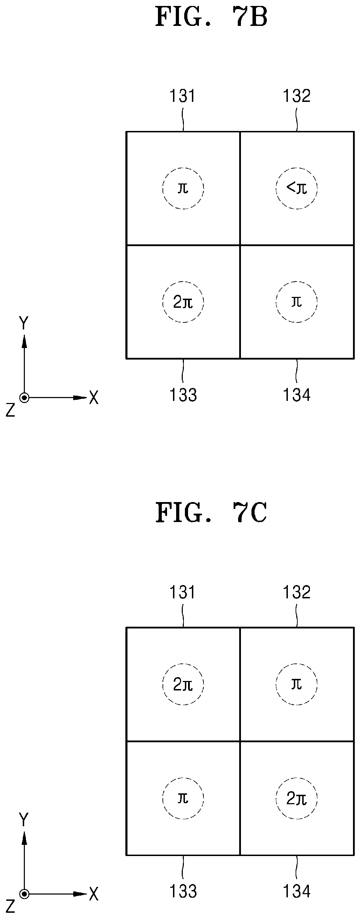

FIG. 7A shows phase profiles of red light and blue light passed through the color separation lens array 130 in the cross section of FIG. 4B, FIG. 7B shows phase of red light passed through the color separation lens array 130 at centers of the pixel corresponding regions 131, 132, 133, and 134, and FIG. 7C shows phase of green light passed through the color separation lens array 130 at centers of the pixel corresponding regions 131, 132, 133, and 134.

Referring to FIGS. 7A and 7B, red light passed through the color separation lens array 130 may have a red light phase profile PPR that is greatest at the center of the red pixel correspondence region 133 and decreases in a direction away from the center of the red pixel correspondence region 133. In detail, the phase of red light at a position immediately after passing through the color separation lens array 130 is greatest at the center of the red pixel correspondence region 133, gradually decreases in the form of concentric circles in directions away from the center of the red pixel correspondence region 133, becomes the smallest at centers of the first green pixel correspondence region 131 and the second green pixel correspondence region 134 in the X direction and the Y direction, and becomes the smallest at the center of the blue pixel correspondence region 132 in diagonal directions. When the phase of red light at the center of the red pixel correspondence region 133 is 2 π, the phase of the red light at the centers of the first green pixel correspondence region 131 and the second green pixel correspondence region 134 may be, for example, from about 0.9 π to about 1.1 π, and the phase of the red light at the blue pixel correspondence region 132 may be less than the phases at the centers of the first green pixel correspondence region 131 and the second green pixel correspondence region 134, e.g., from about 0.6 π to about 0.9 π.

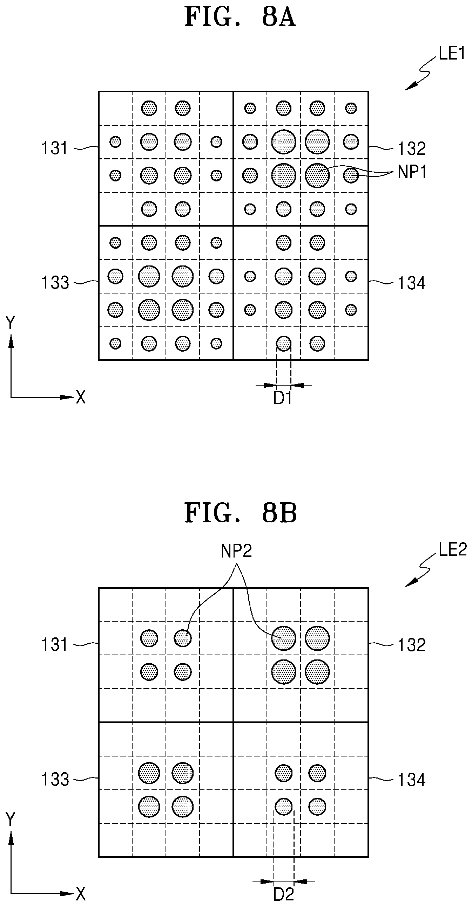

Referring to FIGS. 7A and 7C, green light passed through the color separation lens array 130 may have a second green light phase profile PPG2 that is the greatest at the center of the second green pixel correspondence region 134 and decreases in a direction away from the center of the second green pixel correspondence region 134. Comparing the first green light phase profile PPG1 of FIG. 6A and the second green light phase profile PPG2 of FIG. 8, the second green light phase profile PPG2 is identical to the first green light phase profile PPG1 horizontally moved by 1 pixel pitch in each of the X and Y directions. In other words, the first green light phase profile PPG1 shows the greatest phase at the center of the first green pixel correspondence region 131, whereas the second green light phase profile PPG2 shows the greatest phase at the center of the second green light phase profile PPG2, which is apart from the center of the first green light phase profile PPG1 by one pixel pitch in each of the X direction and the Y direction. The phase profiles of FIGS. 6B and 8C showing phases at the centers of the pixel correspondence regions 131, 132, 133, and 134 may be the same. To describe phase profile of green light based on the second green pixel correspondence region 134, when the phase of green light emitted from the center of the second green pixel correspondence region 134 is set as 2 π, light of the phase from about 0.9 π to about 1.1 π may be emitted from centers of the blue pixel correspondence region 132 and the red pixel correspondence region 133, light of the phase of 2 π may be emitted from the center of the first green pixel correspondence region 131, and light of the phase from about 1.1 π to about 1.5 π may be emitted from the contact point between the first green pixel correspondence region 131 and the second green pixel correspondence region 134.

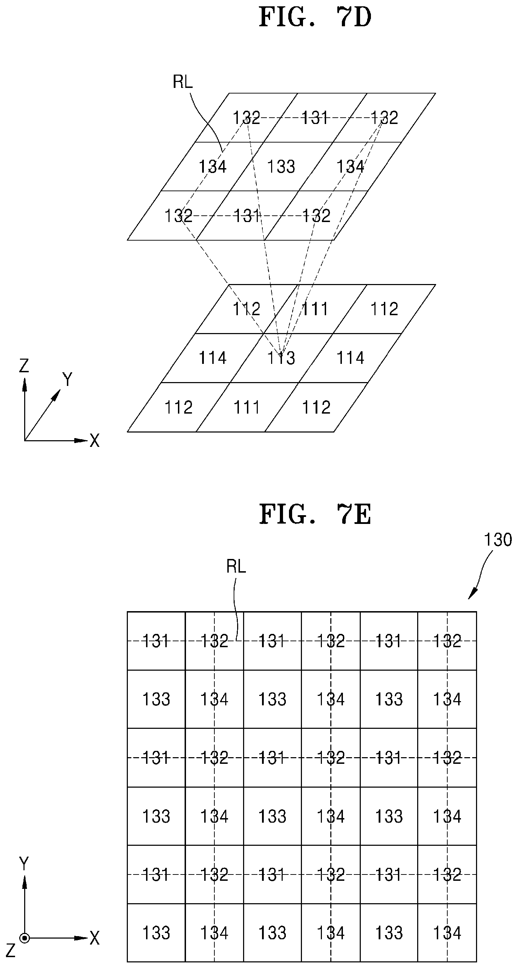

FIG. 7D is a diagram showing an example of a traveling direction of red light incident on a red light converging region, and FIG. 7E is a diagram showing an example of an array of the red light converging region.

Red light is converged to the red pixel 113 by the color separation lens array 130 as shown in FIG. 7D, and red light from the pixel correspondence regions 131, 132, 133, and 134 is incident to the red pixel 113. The phase profile of red light described in FIGS. 7A and 7B converges red light passed through the red light converging region RL, which is formed by connecting centers of four blue pixel correspondence regions 132 adjacent to four vertices of the red pixel correspondence region 132, to the red pixel 113. Accordingly, as shown in FIG. 7E, the color separation lens array 130 may operate as an array of the red light converging region RL for converging red light to a red pixel. The red light converging region RL is larger than a corresponding red pixel 113 and may be, for example, from 1.5 times to 4 times larger than the corresponding red pixel 113. The red light converging region RL may partially overlap the first green light converging region GL1, the second green light converging region GL2, and the blue light converging region BL.

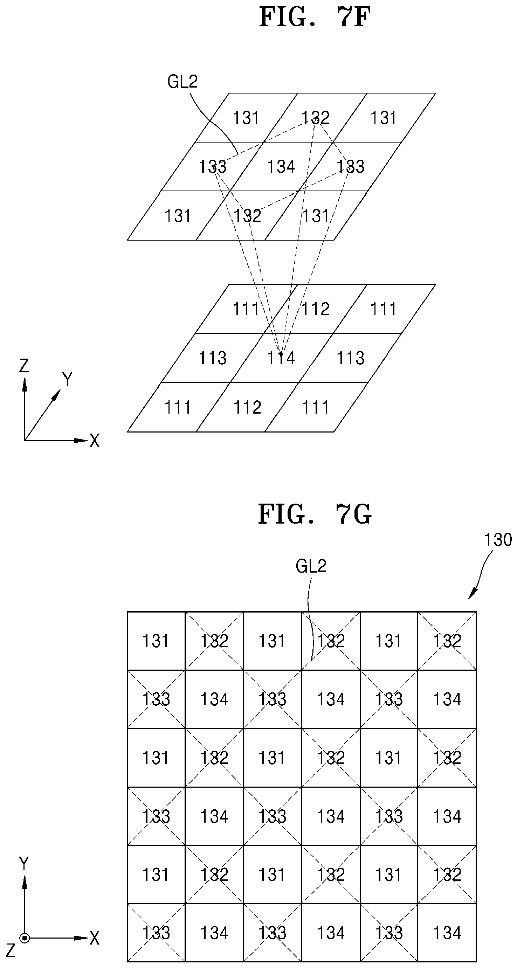

Referring to FIGS. 7F and 7G, green light incident around the second green pixel correspondence region 134 travels similarly as described for the green light incident around the first green pixel correspondence region 131 and, as shown in FIG. 7F, is converged to the second green pixel 114. Therefore, as shown in FIG. 7G, the color separation lens array 130 may operate as an array of the second green light converging region GL2 for converging green light to the second green pixel 114. The second green light converging region GL2 is larger than a corresponding second green pixel 114 and may be, for example, from 1.2 times to 2 times larger than the corresponding second green pixel 114.

FIGS. 8A and 8B are detailed plan views of size profiles of the first nano-posts NP1 of the first lens layer LE1 and the second nano-posts NP2 of the second lens layer LE2 in a color separation lens array provided in a pixel array of an image sensor according to an example embodiment, respectively.

Referring to FIG. 8A, in the first lens layer LE1, the first nano-posts NP1 having relatively large widths are arranged at centers of the first green pixel correspondence region 131, the blue pixel correspondence region 132, the red pixel correspondence region 133, and the second green pixel correspondence region 134, and the first nano-posts NP1 having relatively small widths are arranged in peripheral regions of the first green pixel correspondence region 131, the blue pixel correspondence region 132, the red pixel correspondence region 133, and the second green pixel correspondence region 134. Comparing the sizes of the first nano-posts NP1 arranged at centers of respective pixel correspondence regions, the first nano-post NP1 of the blue pixel correspondence region 132 has the largest width, the first nano-posts NP1 of the first green pixel correspondence region 131 and the second green pixel correspondence region 134 have the smallest width, and the first nano-post NP1 of the red pixel correspondence region 133 have an intermediate width. According to an example embodiment, the widths of the first nano-posts NP1 at or closer to a center region of a pixel region is larger the widths of the first nano-posts NP1 farther away from the center region of a pixel region (i.e., farther away as compare to the first nano-posts NP1 that are at or closer to the center region of a pixel region.

The first lens layer LE1 is a narrow-CD layer. In other words, widths D1 of the first nano-posts NP1 provided in the first lens layer LE1 may have all of values less than a predetermined reference size wc and values greater than the reference size wc. The reference size wc may be, for example, 80nm ≤ wc ≤ 200nm. The reference size wc may be, for example, 80nm ≤ wc ≤ 100nm. The reference size wc may be, for example, 170nm ≤ wc ≤ 200nm. When the width D1 of the first nano-post NP1 having the smallest width from among the first nano-posts NP1 arranged in the first lens layer LE1 is denoted by w1 and the width D1 of the first nano-post NP1 having the largest width from among the first nano-posts NP1 arranged in the first lens layer LE1 is denoted by w3, w1 and w3 may have ranges of 50nm ≤ w1 ≤ 90nm and 200nm ≤ w3 ≤ 400nm, respectively. Alternatively, w1 may have a range of 70 nm ≤ w1 ≤ 80 nm.

Referring to FIG. 8B, in the second lens layer LE2, unlike the first lens layer LE1, the second nano-posts NP2 having the same size are arranged only in relatively center regions of the first green pixel correspondence region 131, the blue pixel correspondence region 132, the red pixel correspondence region 133, and the second green pixel correspondence region 134. Comparing the sizes of the second nano-posts NP2 arranged at centers of respective pixel correspondence regions, the second nano-post NP2 of the blue pixel correspondence region 132 has the largest width, the second nano-posts NP2 of the first green pixel correspondence region 131 and the second green pixel correspondence region 134 have the smallest width, and the second nano-post NP2 of the red pixel correspondence region 133 have an intermediate width.

The second lens layer LE2 is a wide-CD layer. In other words, widths D2 of the second nano-posts NP2 provided in the second lens layer LE2 are all equal to or greater than the reference size wc. When the width D2 of the second nano-post NP2 having the smallest width from among the second nano-posts NP2 arranged in the second lens layer LE1 is denoted by w2 and the width D2 of the second nano-post NP2 having the largest width from among the second nano-posts NP2 arranged in the second lens layer LE1 is denoted by w4, w2 is greater than w1 and may be, for example, in the range of 100nm ≤ w2 ≤ 110nm. w4 may have a range of 200 nm ≤ w4 ≤ 400 nm. w4 may be equal to w3, which is the maximum width of the first nano-post NP1.

The sizes and arrangements of the first nano-posts NP1 and the second nano-posts NP2 are examples for forming the phase profile described in FIGS. 6A to 6G and FIGS. 7A to 7G, and based on the predetermined reference size wc, nano-posts having widths less than the reference size wc may be provided in any one layer only. However, various modifications may be made therein.

In the color separation lens array 130 according to an example embodiment, the minimum width of nano-posts NP1 and NP2 provided therein may be increased by such arrangements of the nano-posts NP1 and NP2, and the overall width profile range, that is, a difference between the minimum width and the maximum width may also be reduced.

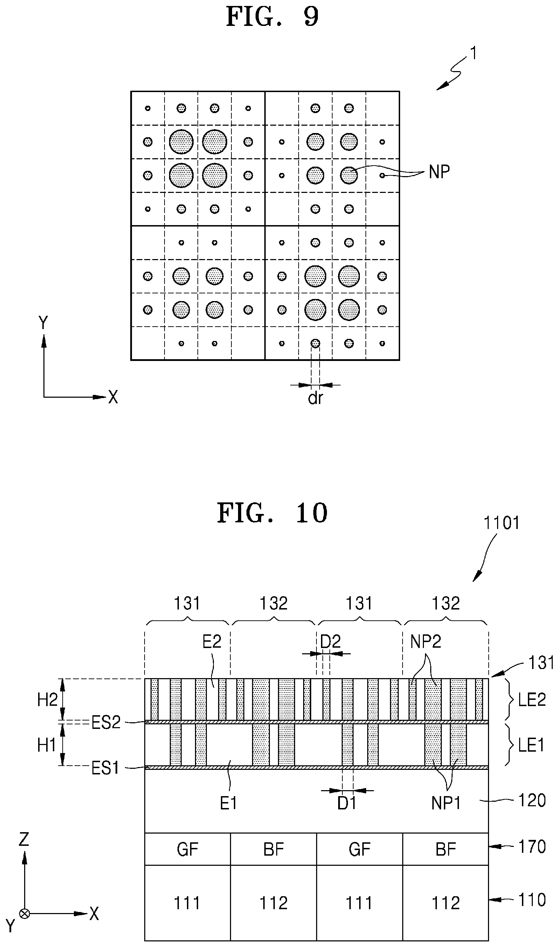

FIG. 9 is a detailed plan view of a size profile of nano-posts provided in a color separation lens array according to a comparative example.

In a color separation lens array 1 of the comparative example, a plurality of nano-posts NP are arranged in a single layer. In this case, to implement the above-described phase profile, the profile of widths dr of the nano-posts NP becomes wider. For example, when the width of the smallest nano-post NP and the width of the largest nano-post NP are denoted by dr1 and dr2, dr2 is similar to the upper limit of widths of the first nano-posts NP1 and the second nano-posts NP2 in the color separation lens array 130 according to an example embodiment, but dr1 may be less than w1, which is the lower limit of the widths of the first nano-posts NP1 and the second nano-posts NP2 in the color separation lens array 130 according to an example embodiment. Here, dr1 may be, for example, 70 nm or less, 60 nm or less, 50 nm or less, or 40 nm or less. In the color separation lens array 1 according to the comparative example, the minimum width of the nano-posts NP to be implemented is less than that of the color separation lens array 130 of the example embodiment, and thus the width range of nano-posts is also wider.

In a process of manufacturing nano-posts, a photolithography apparatus suitable for the minimum critical dimension (CD) needs to be used. However, when the minimum width of nano-posts to be implemented is too small or the profile of widths to be implemented in one process wafer is wide, a defect may occur.

According to an example embodiment, by arranging a plurality of nano-posts NP1 and NP2 in two layers including a narrow-CD layer and a wide-CD layer according to a predetermined reference size criterion, the minimum width to be implemented may become larger than that of the comparative example, and thus process defects may be minimized.

Hereinafter, various examples in which the nano-posts NP1 and NP2 are arranged to minimize process defects as stated above will be described. FIGS. 10 to 11, which will be described in various examples, are cross-sectional views corresponding to the cross-sectional view of FIG. 4A, and the cross-sectional view corresponding to FIG. 4B is omitted for convenience.

FIG. 10 is a cross-sectional view of a pixel array of an image sensor according to another example which does not fall within the scope of the claims.

According to an example, a color separation lens array 131 provided in a pixel array 1101 of FIG. 10 is different from the color separation lens array 130 of FIGS. 4A and 4B, in that, the first lens layer LE1 is changed to be a wide-CD layer and the second lens layer LE2 is changed to be a narrow-CD layer. In other words, the widths D1 of the first nano-posts NP1 of the first lens layer LE1 are all equal to or greater than the reference size wc, and the widths D2 of the second nano-posts NP2 of the second lens layer LE2 include both widths less than the reference size wc and widths greater than the reference size wc.

The remaining configuration is substantially the same as that of the color separation lens array 130 described above.

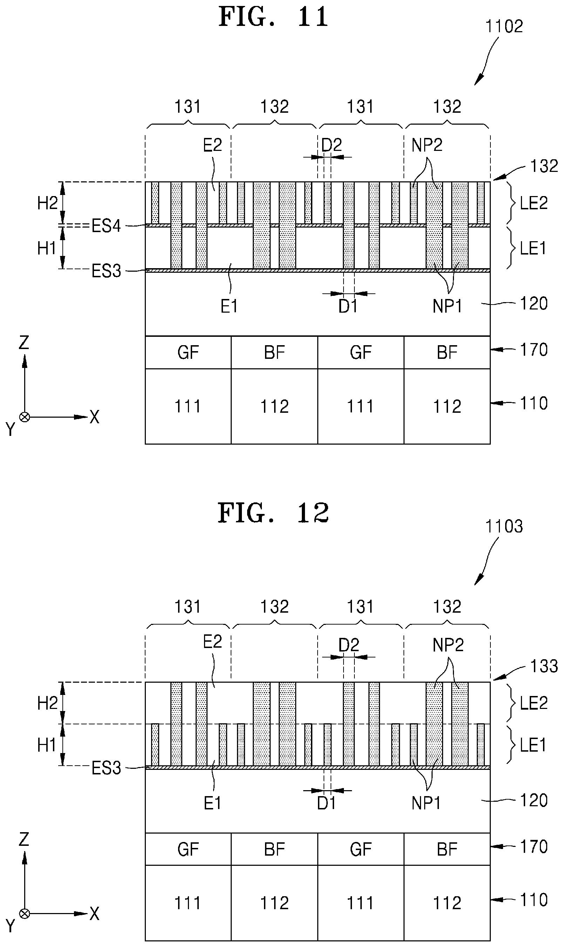

FIG. 11 is a cross-sectional view of a pixel array of an image sensor according to another example which does not fall within the scope of the claims.

Similar to the color separation lens array 131 of FIG. 10, in a color separation lens array 132 provided in a pixel array 1102 of FIG. 11, the first lens layer LE1 is a wide-CD layer and the second lens Layer LE2 is a narrow-CD layer.

A first etch stop layer ES3 is provided between the spacer layer 120 and the first lens layer LE1, and a second etch stop layer ES4 is provided between the first lens layer LE1 and the second lens layer LE2.

The second etch stop layer ES4 provided between the first lens layer LE1 and the second lens layer LE2 is patterned to a shape contacting some of the second nano-posts NP2 instead of being formed on entire surface between the first lens layer LE1 and the second lens layer LE2. The second etch stop layer ES4 contacts the bottom surfaces of the second nano-posts NP2 having widths D2 less than the reference size wc from among the second nano-posts NP2 of the second lens layer LE2, which is a narrow-CD layer. From among the second nano-posts NP2, some of the second nano-posts NP2 having widths D2 equal to or greater than the reference size wc may contact and be connected to the first nano-posts NP1 of the first lens layer LE1.

In other words, the second etch stop layer ES4 may contact all of the second nano-posts NP2 having the widths D2 less than the reference size wc and may also contact some of the second nano-posts NP2 having the widths D2 equal to or greater than the reference size wc. However, some of the second nano-posts NP2 having the widths D2 equal to or greater than the reference size wc may contact and be directly connected to the first nano-posts NP1 of the first lens layer LE1, and the other some of the second nano-posts NP2 having the widths D2 equal to or greater than the reference size wc may contact the second etch stop layer ES4 without directly contacting the first nano-posts NP1 of the first lens layer LE1.

Widths D2 and D1 of the second nano-posts NP2 and the first nano-posts NP1 directly connected to each other in the vertical direction may be the same and may have be equal to or greater than a predetermined reference width. This predetermined reference width will be referred to as a reference width wt. The reference width wt may be greater than the reference size wc, or a difference between the reference width wt and the reference size wc may be sufficiently large, e.g., 50 nm or greater. The widths D2 and D1 of the second nano-posts NP2 and the first nano-posts NP1 that are directly connected to each other in the vertical direction may be 100 nm or greater, 150 nm or greater, 200 nm or greater, 250 nm or greater, or 300 nm or greater.

As described above, the criterion for the widths of the second nano-posts NP2 and the first nano-posts NP1 connected to each other in the vertical direction may be determined in consideration of a height H1 of the first lens layer LE1, that is, the height of the first nano-posts NP1. The height H1 of the first nano-posts NP1 may be less than a height H2 of the second nano-posts NP2. The height H1 of the first nano-posts NP1 may be 400 nm or less, 350 nm or less, 300 nm or less, 250 nm or less, or 200 nm or less.

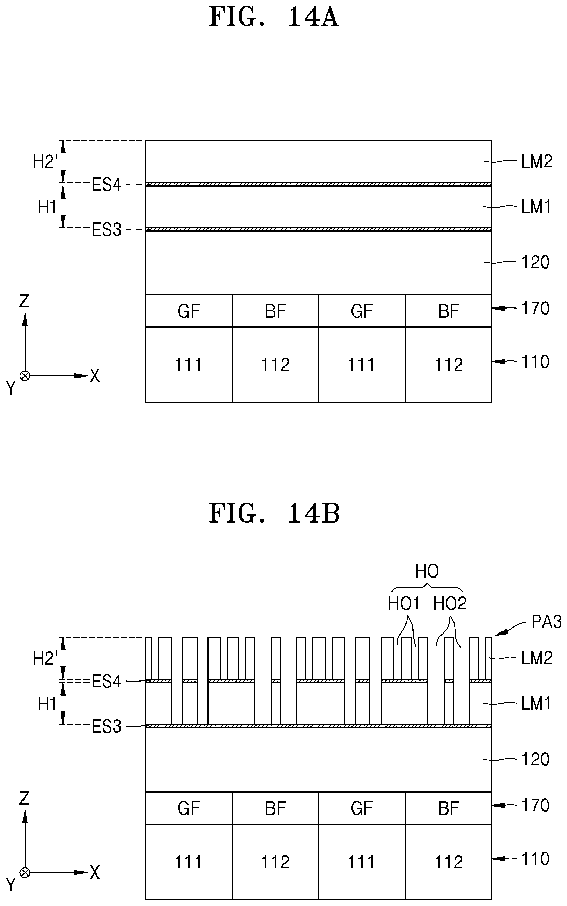

Setting the height H1 of the first nano-posts NP1 to be less than the height H2 of the second nano-posts NP2 may be because of a process condition in a process of fabricating the pixel array 1102 of the present example (FIG. 14B) that holes having the height H2 for the second nano-posts NP2 and holes having a height H1 +H2 for vertical connection of the first nano-posts NP1 and the second nano-posts NP2 are formed together. However, the disclosure is not limited thereto, and the heights H1 and H2 may be appropriately set within ranges in which a plurality of holes having different depths and widths may be simultaneously formed. For example, the height H1 may be equal to or greater than the height H2.

The range of the sum of the height H1 of the first nano-post NP1 and the height H2 of the second nano-post NP2 (i.e., H1+H2) may be from about 800 nm to about 1000 nm.

The thickness of the first etch stop layer ES3 may be determined in consideration of an etch rate of a material to be etched. An etch rate is related to an amount of a material to be etched, that is, a thickness and a width of a material region to be etched. The first etch stop layer ES3 of the present example is a layer serving as an etch stop in an etching process of simultaneously forming nano-posts NP1 and NP2 having relatively large widths from among the first nano-posts NP1 and the second nano-posts NP2 included in the first lens layer LE1 and the second lens layer LE2. In other words, since the thickness of the material region to be etched is H1+H2 or greater and the width of the material region to be etched is greater than the reference size wc, the thickness of the first etch stop layer ES3 may be, for example, slightly greater than the first etch stop layer ES1 of the color separation lens array 130 or 131 described above. The first etch stop layer ES3 may have a thickness from about 3 nm to about 30 nm, a thickness of 10 nm or greater, or a thickness of 20 nm or greater.

In the same regard, the thickness of the second etch stop layer ES4 may be determined in consideration of an etch rate of a material to be etched. An etch rate depends on an amount of a material to be etched, that is, the height H2 of the second lens layer LE2 and the width D2 of the second nano-posts NP2. In the present example, since the second etch stop layer ES4 serves as an etch stop only for the second nano-posts NP2 having relatively small widths from among the second nano-posts NP2, the thickness of the second etch stop layer ES4 may be slightly small. The thickness of the second etch stop layer ES4 may be less than the thickness of the first etch stop layer ES3. Also, for example, the thickness of the second etch stop layer ES4 may be less than that of the second etch stop layer ES2 provided in the above-stated color separation lens arrays 130 or 131. The second etch stop layer ES4 may have a thickness from about 3 nm to about 30 nm, a thickness of 20 nm or less, or a thickness of 10 nm or less.

The structure of the color separation lens array 132 of the present example is formed by patterning some of the first nano-posts NP1 and the second nano-posts NP2 having relatively large widths through one patterning without dividing processes for the first lens layer LE1 and the second lens layer LE2. A method of fabricating the same will be described in detail with reference to FIGS. 14A to 14E.

FIG. 12 is a cross-sectional view of a pixel array of an image sensor according to another example embodiment.

In a color separation lens array 133 provided in a pixel array 1103 of FIG. 12, the first lens layer LE1 is a narrow-CD layer and the second lens layer LE2 is a wide-CD layer. In other words, the first lens layer LE1 includes the first nano-posts NP1 having widths D1 less than the reference size wc and the first nano-posts NP1 having widths D1 equal to or greater than the reference size wc, and the widths D2 of the second nano-posts NP2 included in the second lens layer LE2 are all equal to or greater than the reference size wc.

Some of the first nano-posts NP1 of the first lens layer LE1 and some of the second nano-posts NP2 of the second lens layer LE2 may directly contact and be connected to each other in the vertical direction. The widths D2 and D1 of the second nano-posts NP2 and the first nano-posts NP1 directly connected to each other in the vertical direction may be the same and, as described above with reference to FIG. 11, equal to or greater than the reference width wt. The reference width wt may be greater than the reference size wc, or a difference between the reference width wt and the reference size wc may be sufficiently large, e.g., 50 nm or greater. For example, the widths D2 and D1 of the second nano-posts NP2 and the first nano-posts NP1 that are directly connected to each other in the vertical direction may be 100 nm or greater, 150 nm or greater, 200 nm or greater, 250 nm or greater, or 300 nm or greater.

From among the first nano-posts NP1, some of the first nano-posts NP1 having widths D1 equal to or greater than the reference size wc may contact and be connected to the second nano-posts NP2 of the second lens layer LE2. From among the first nano-posts NP1, not all of the first nano-posts NP1 having widths D1 equal to or greater than the reference size wc may be connected to the second nano-posts NP2 of the second lens layer LE2. In other words, from among the first nano-posts NP1, the other some of the first nano-posts NP1 having widths D1 equal to or greater than the reference size wc may not be connected to the second nano-posts NP2 of the second lens layer LE2.

Although FIG. 12 shows that all of the second nano-posts NP2 arranged in the second lens layer LE2 are connected to the first nano-posts NP1 of the first lens layer LE1, it is merely an example, and the disclosure is not limited thereto. Second nano-posts NP2 not connected to the first nano-posts NP1 may be provided in the second lens layer LE2.

In this example embodiment, the first nano-posts NP1 having widths less than the reference size wc are provided only in the first lens layer LE1, which is a narrow-CD layer, and some of the first nano-posts NP1 and the second nano-posts NP2 having relatively large widths are formed through one patterning without dividing processes for the first lens layer LE1 and the second lens layer LE2. Therefore, there is no etch stop layer between the first lens layer LE1 and the second lens layer LE2.

The thickness of the first etch stop layer ES3 may be determined in consideration of an etch rate of a material to be etched. An etch rate is related to an amount of a material to be etched, that is, a thickness and a width of a material region to be etched. In the present embodiment, since the thickness of the material region to be etched is greater than H1+H2 and the width of the material region to be etched is greater than the reference size wc, the thickness of the first etch stop layer ES3 may be, for example, slightly greater than the first etch stop layer ES1 of the color separation lens array 130 or 131 described above. The first etch stop layer ES3 may have a thickness from about 3 nm to about 30 nm, a thickness of 10 nm or greater, or a thickness of 20 nm or greater.

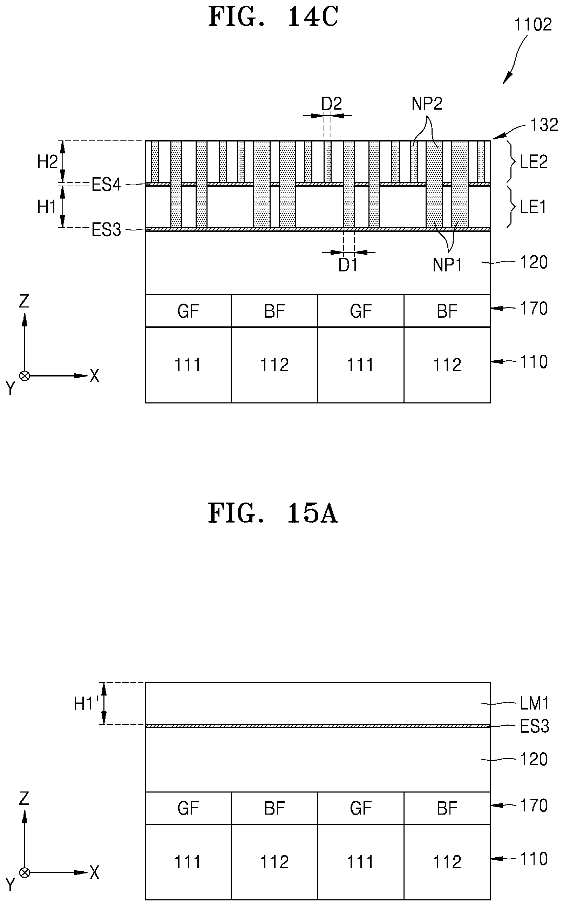

The structure of the color separation lens array 132 of the present embodiment is formed by patterning some of the first nano-posts NP1 and the second nano-posts NP2 having relatively large widths through one patterning without dividing processes for the first lens layer LE1 and the second lens layer LE2. A method of fabricating the same will be described in detail with reference to FIGS. 15A to 15F.

Hereinafter, a method of fabricating above-described image sensor pixel arrays 1100, 1101, 1102, and 1103 will be described.

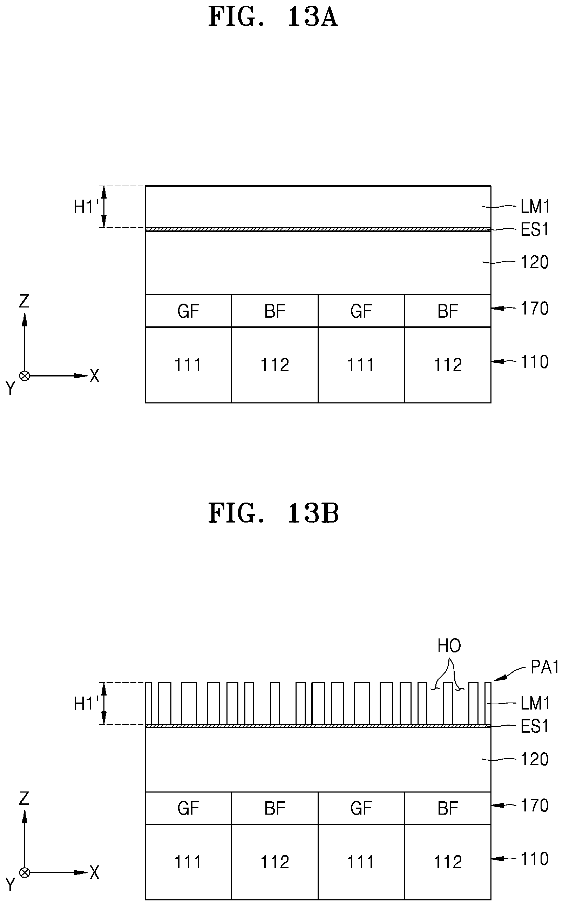

FIGS. 13A to 13F are diagrams for describing a method of manufacturing an image sensor according to an example which does not fall within the scope of the claims.

Referring to FIG. 13A, the spacer layer 120, the first etch stop layer ES1, and a first material layer LM1 are formed on the sensor substrate 110.

The color filter array 170 may be formed between the sensor substrate 110 and the spacer layer 120, but the color filter array 170 may be omitted.

According to an example, the material constituting the first surrounding material layer E1 described above with reference to FIGS. 4A and 4B may be used for the first material layer LM1. A thickness H1' of the first material layer LM1 is set to correspond to the height H1 of the first nano-posts NP1 to be formed. The height H1' may be the same as the height H1 or may be greater than the height H1 in consideration of a CMP process that may be performed later.

The first etch stop layer ES1 may include a material having an etch selectivity greater than that of the first material layer LM1. The first etch stop layer ES1 may protect the spacer layer 120 during an etching process during a process of patterning the first material layer LM1. The first etch stop layer ES1 may include HfO₂ and may have a thickness from about 3 nm to about 30 nm.

Next, as shown in FIG. 13B, the first material layer LM1 is patterned into a first pattern PA1 through a photolithography process. The width of a plurality of holes HO formed in the first material layer LM1 according to the first pattern PA1 corresponds to the width of the first nano-posts NP1 to be formed.

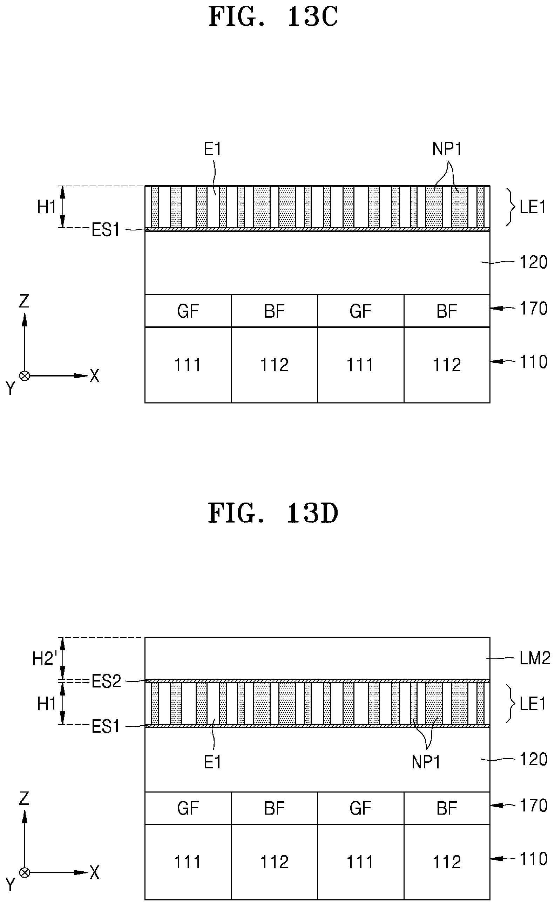

Next, as shown in FIG. 13C, the first lens layer LE1 including a plurality of first nano-posts NP1 is formed by filling the plurality of holes HO with a material having a refractive index different from that of the first material layer LM1. In this operation, the material constituting the first nano-posts NP1 may fill the holes HO and be deposited up to the upper region of the first material layer LM1. A portion of the material deposited onto the first material layer LM1 may be removed through a CMP process, and the first lens layer LE1 having the height H1 may be formed.

Next, as shown in FIG. 13D, the second etch stop layer ES2 and a second material layer LM2 are sequentially formed on the first lens layer LE1. The material constituting the second surrounding material layer E2 described above with reference to FIGS. 4A and 4B may be used for the second material layer LM2. The second material layer LM2 may include the same material as the first material layer LM1, but the disclosure is not limited thereto. A thickness H2' of the second material layer LM2 is set to correspond to the height H2 of the second nano-posts NP2 to be formed. The height H2' may be the same as the height H2 or may be greater than the height H2 in consideration of a CMP process that may be performed later.

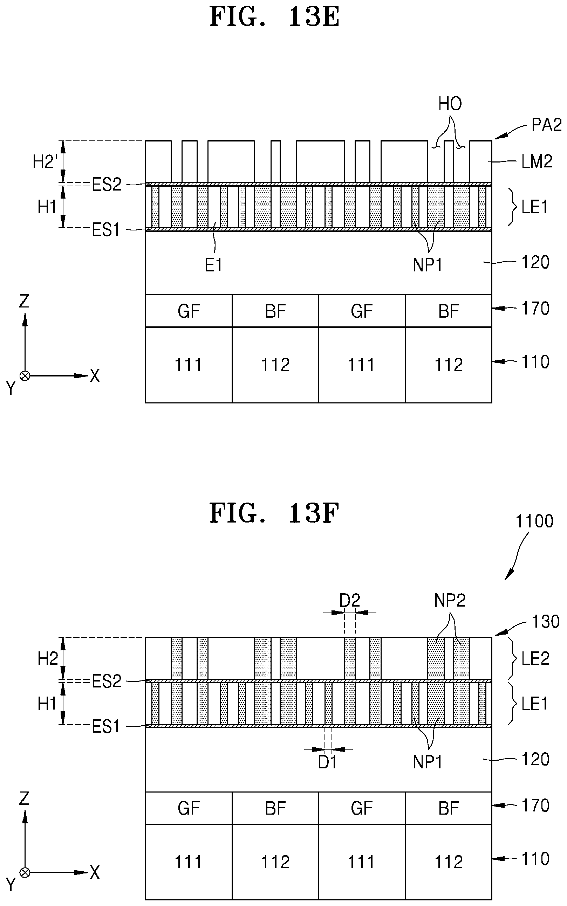

Next, as shown in FIG. 13E, the second material layer LM2 is patterned into a second pattern PA2 to form the plurality of holes HO.

Next, as shown in FIG. 13F, the second lens layer LE2 including a plurality of second nano-posts NP2 is formed by filling the plurality of holes HO with a material having a refractive index different from that of the second material layer LM2. In this operation, the material constituting the second nano-posts NP2 may fill the holes HO and be deposited up to the upper region of the second material layer LM2. A portion of the material deposited onto the second material layer LM2 may be removed through a CMP process, and the first lens layer LE2 having the height H2 may be formed.

According to an example, a process of forming a protective layer for protecting the color separation lens array 130 on the color separation lens array 130 may be further performed. The protective layer may include a material serving as an anti-reflection layer.

The anti-reflection layer may have a structure in which one or a plurality of layers are stacked. For example, the anti-reflective layer may include one layer including a material different from the material constituting the second lens layer LE2, or a plurality of material layers having different refractive indices from one another.

In the regard, the image sensor pixel array 1100 including the color separation lens array 130 similar to that shown in FIG. 4A may be fabricated.

When the above-described operation is modified to pattern the first material layer LM1 into the second pattern PA2 and pattern the second material layer LM2 into the first pattern PA1, as shown in FIG. 11, an image sensor pixel array 1101 including the color separation lens array 131 in which the first lens layer LE1 is a wide-CD layer and the second lens layer LE2 is a narrow-CD layer may be fabricated.

FIGS. 14A to 14E are diagrams for describing a method of manufacturing an image sensor according to another example which does not fall within the scope of the claims.

First, as shown in FIG. 14A, on the sensor substrate 110, the spacer layer 120, the first etch stop layer ES3, the first material layer LM1, the second etch stop layer ES4, and the second material layer LM2 are sequentially formed.

The thickness H1 of the first material layer LM1 may be set to correspond to the height of the first nano-posts NP1 to be fabricated. A thickness H2' of the second material layer LM2 is set to correspond to the height H2 of the second nano-posts NP2 to be formed. The height H2' may be the same as the height H2 or may be greater than the height H2 in consideration of a CMP process that may be performed later.

The thickness H1 of the first material layer LM1 and the thickness H2' of the second material layer LM2 may be determined in consideration of process conditions in a next operation of FIG. 14B. The thickness H1 of the first material layer LM1 may be less than the thickness H2' of the second material layer LM2 to facilitate a process of simultaneously forming narrow and shallow holes and wide and deep holes by etching the first material layer LM1 and the second material layer LM2. However, the disclosure is not limited thereto, and the thickness H1 of the first material layer LM1 and the thickness H2' of the second material layer LM2 may be equal to or greater than those stated above within the range in which the above process is possible.

The first etch stop layer ES3 may include a material having an etch selectivity greater than that of the first material layer LM1 and may protect the spacer layer 120 in an etching process of patterning the first material layer LM1. The thickness of the first etch stop layer ES3 may be determined in consideration of an etch rate of a material to be etched, and the etch rate is related to an amount of the material to be etched. In the method of the present example, since the first etch stop layer ES3 serves as an etch stop in a process of simultaneously etching the first material layer LM1 and the second material layer LM2 to widths equal to or greater than the reference size wc, the first etch stop layer ES3 may be slightly thicker than the first etch stop layer ES1 in the method of FIG. 13A. The first etch stop layer ES3 may have a thickness from about 3 nm to about 30 nm, a thickness of 10 nm or greater, or a thickness of 20 nm or greater.

The second etch stop layer ES4 may include a material having a higher etch selectivity than the second material layer LM2. In the method of the present example, since the second etch stop layer ES4 serves as an etch stop only for the second nano-posts NP2 having relatively small widths from among the second nano-posts NP2 to be formed, the thickness of the second etch stop layer ES4 may be slightly small. For example, the second etch stop layer ES4 may be formed to a thickness less than that of the second etch stop layer ES2 described with reference to FIG. 13D. The second etch stop layer ES4 may have a thickness from about 3 nm to about 30 nm, a thickness of 20 nm or less, or a thickness of 10 nm or less.

Referring to FIG. 14B, a plurality of holes HO are formed by patterning a stacked structure of the first material layer LM1, the second etch stop layer ES4, and the second material layer LM2 into a third pattern PA3.

The plurality of holes HO have two types of depths as illustrated in FIG. 14B. From among the plurality of holes HO, holes HO1 having a relatively small width are formed to a depth for exposing the second etch stop layer ES4 by etching the second material layer LM2, and holes HO2 having a relatively large width are formed to a depth for exposing the first etch stop layer ES3 by etching the second material layer LM2, the second etch stop layer ES4, and the first material layer LM1. For example, the holes HO1 are smaller than the holes HO2. Here, a width criterion by which etching depths are determined differently may be determined with reference to the above-stated reference width wt. In other words, holes HO2 having a width equal to or greater than the reference width wt may be formed to have a large depth, and holes HO1 having a width less than or equal to the reference width wt may be formed to have a small depth.

The holes HO1 having a width less than the reference size wc are formed to a depth H2' to expose the second etch stop layer ES4. From among the holes HO having a width equal to or greater than the reference size wc, holes HO1 having a width less than the reference width wt may be formed to a depth H2' to expose the second etch stop layer ES4.

Holes HO2 having a width equal to or greater than the reference width wt are formed to a depth by which the first etch stop layer ES3 is exposed. The reference width wt may be greater than the reference size wc, or a difference between the reference width wt and the reference size wc may be sufficiently large, e.g., 50 nm or greater. As described above, the reference size wc may be equal to or greater than 80 nm and less than or equal to 100 nm. The widths of the holes HO which penetrating through the first material layer LM1 and the second material layer LM2 together may be sufficiently larger than the reference size wc, e.g., 100 nm or greater, 150 nm or greater, 200 nm or greater, 250 nm or greater, or 300 nm or greater.

The width criterion for determining the depth of the illustrated holes HO may be determined, such that the holes HO having two types of depths may be formed through one photolithography process. Since an etch rate increases as an amount of a material to be etched increases, the holes HO1 having a relatively small width may be formed to a small depth and the holes HO2 having a relatively large width may be formed to a large depth, through one etching process.

Next, referring to FIG. 14C, the plurality of holes HO are filled with a material having a refractive index different from those of the first material layer LM1 and the second material layer LM2, thereby forming the first lens layer LE1 including the first nano-posts NP1 and the second lens layer LE2 including the second nano-posts NP2. In this operation, the material constituting the first nano-posts NP1 and the second nano-posts NP2 may fill the holes HO and be deposited up to the upper region of the second material layer LM2. A portion of the material deposited onto the second material layer LM2 may be removed through a CMP process, and the second lens layer LE2 having the height H2 may be formed.

In the regard, the image sensor pixel array 1102 including the color separation lens array 132 similar to that shown in FIG. 11 may be fabricated.

FIGS. 15A to 15F are diagrams for describing a method of manufacturing an image sensor according to another example embodiment.

Referring to FIG. 15A, the spacer layer 120, the first etch stop layer ES3, and a first material layer LM1 are formed on the sensor substrate 110.

A thickness H1' of the first material layer LM1 is set to correspond to the height H1 of the first nano-posts NP1 to be formed. The height H1' may be the same as the height H1 or may be greater than the height H1 in consideration of a CMP process that may be performed later.

The thickness of the first etch stop layer ES3 may be determined in consideration of an etch rate of a material to be etched. In the method of the present embodiment, since the first etch stop layer ES3 serves as an etch stop in a process of simultaneously etching the first material layer LM1 and the second material layer LM2, the first etch stop layer ES3 may be slightly thicker than the first etch stop layer ES1 like the first etch stop layer ES3 in the method of FIG. 14A. The first etch stop layer ES3 may have a thickness from about 3 nm to about 30 nm, a thickness of 10 nm or greater, or a thickness of 20 nm or greater.

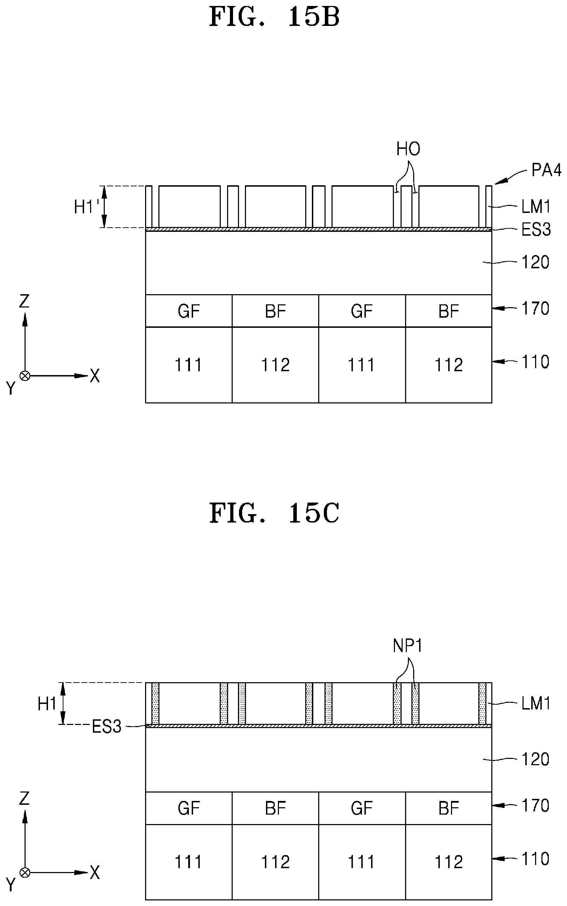

Referring to FIG. 15B, the first material layer LM1 is patterned into a fourth pattern PA4 to form the plurality of holes HO. The fourth pattern PA4 is a pattern for forming nano-posts having a relatively small width. In other words, widths of the plurality of holes HO formed according to the fourth pattern PA4 are all less than the reference width wt. In other words, the plurality of holes HO formed according to the fourth pattern PA4 include holes HO having widths less than the reference size wc and may also include holes HO having widths equal to or greater than the reference size wc and less than the reference width wt.

Next, referring to FIG. 15C, the first nano-posts NP1 are formed by filling the plurality of holes HO with a material having a refractive index different from that of the first material layer LM1. In this operation, the material constituting the first nano-posts NP1 may fill the holes HO and be deposited up to the upper region of the first material layer LM1. A portion of the material deposited onto the first material layer LM1 may be removed through a CMP process, and the first material layer LM1 may have the height H1.

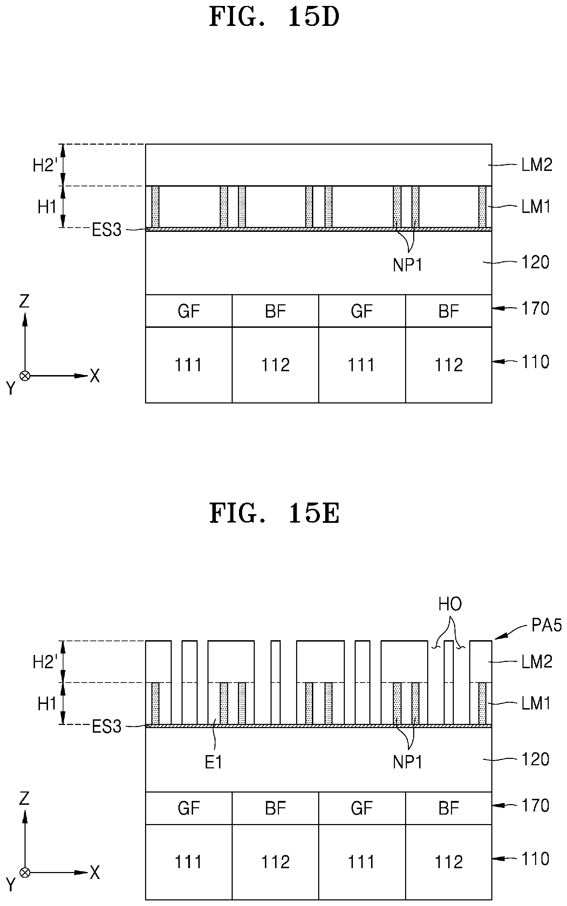

Next, referring to FIG. 15D, the second material layer LM2 is formed over the structure including the first nano-posts NP1 and the patterned first material layer LM1. A thickness H2' of the second material layer LM2 is set to correspond to the height H2 of the second nano-posts NP2 to be formed. The height H2' may be the same as the height H2 or may be greater than the height H2 in consideration of a CMP process that may be performed later.

As shown in FIG. 15E, the first material layer LM1 and the second material layer LM2 are patterned according to a fifth pattern PA5. The fifth pattern PA5 is a pattern for forming the first nano-posts NP1 and the second nano-posts NP2 having widths equal to or greater than the reference width wt. All of the plurality of holes HO formed according to the fifth pattern PA5 have widths equal to or greater than the reference width wt. The reference width wt may be greater than the reference size wc, or a difference between the reference width wt and the reference size wc may be sufficiently large, e.g., 50 nm or greater. As described above, the reference size wc may be equal to or greater than 80 nm and less than or equal to 100 nm. In other words, the holes HO formed according to the fifth pattern PA5 may have widths sufficiently larger than the reference size wc, e.g., 100 nm or greater, 150 nm or greater, 200 nm or greater, 250 nm or greater, or 300 nm or greater, and is formed to a depth for exposing the first etch stop layer ES3.

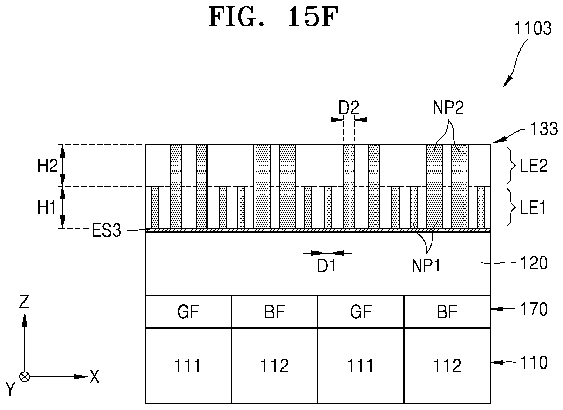

Next, as shown in FIG. 15F, when the plurality of holes HO are filled with a material having a refractive index different from those of the second material layer LM2 and the first material layer LM1, the first nano-post NP1 and second nano-posts NP2 having widths equal to or greater than a predetermined width are formed. In this operation, the material constituting the first nano-posts NP1 and the second nano-posts NP2 may fill the holes HO and be deposited up to the upper region of the second material layer LM2. A portion of the material deposited onto the second material layer LM2 may be removed through a CMP process, and the second lens layer LE2 having the height H2 may be formed.

In the regard, the image sensor pixel array 1103 including the color separation lens array 133 similar to that shown in FIG. 12 may be fabricated.

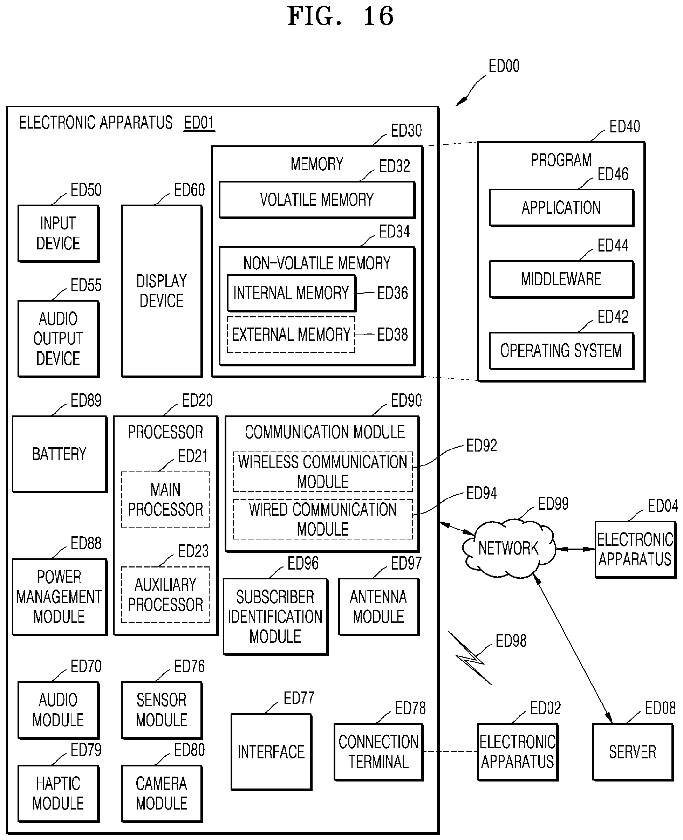

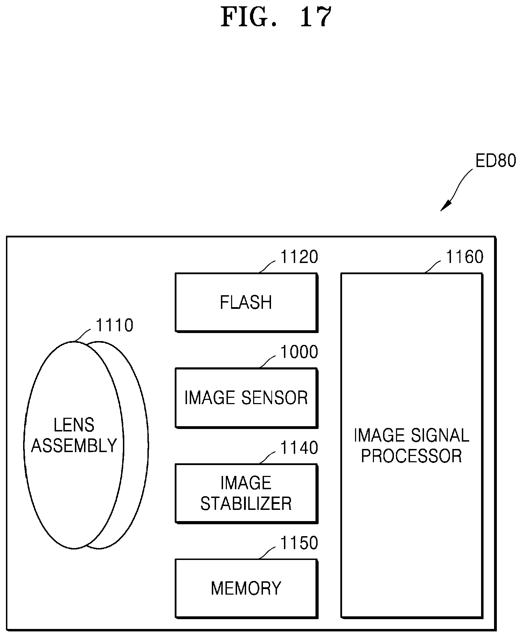

FIG. 16 is a block diagram schematically showing an electronic device including an image sensor according to example embodiments, and FIG. 17 is a block diagram schematically showing a camera module included in the electronic device of FIG. 16.

FIG. 16 shows an example of an electronic device ED01 including the image sensor 1000. Referring to FIG. 16, in a network environment ED00, the electronic device ED01 may communicate with another electronic device ED02 through a first network ED98 (e.g., a short-range wireless communication network) or may communicate with another electronic device ED04 and/or a server ED08 through a second network ED99 (e.g., a long-distance wireless communication network). The electronic device ED01 may communicate with the electronic device ED04 through the server ED08. The electronic device ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identifying module ED96, and/or an antenna module ED97. In the electronic device ED01, some of these components (e.g., the display device ED60) may be omitted or other components may be added. Some of these components may be implemented as one integrated circuit. For example, the sensor module ED76 (e.g., a fingerprint sensor, an iris sensor, and an illuminance sensor) may be implemented by being embedded in the display device ED60 (e.g., a display).

The processor ED20 may execute software (e.g., a program ED40) to control one or a plurality of other components (hardware components, software components, etc.) of the electronic device ED01 connected to the processor ED20 or perform various data processing or operations. As a part of data processing or operation, processor ED20 may load commands and/or data received from other components (e.g., the sensor module ED76 and the communication module ED90) into a volatile memory ED32, process commands and/or data stored in the volatile memory ED32, and store result data in a non-volatile memory ED34. The processor ED20 includes a main processor ED21 (e.g., a central processing unit and an application processor) and a co-processor ED23 (e.g., a graphics processing unit, an image signal processor, a sensor hub processor, and a communication processor) that may be operated independently or together with the main processor ED21. The co-processor ED23 may use less power than the main processor ED21 and may perform a specialized function.

The co-processor ED23 may control functions and/or states related to some components (e.g., the display device ED60, the sensor module ED76, and the communication module ED90) of the electronic device ED01 in place of the main processor ED21 while the main processor ED21 is in an inactive state (sleep state) or together with the main processor ED21 while the main processor ED21 is in an active state (application executing state). The co-processor ED23 (e.g., an image signal processor and a communication processor) may be implemented as a part of other functionally related components (e.g., the camera module ED80 and the communication module ED90).

The memory ED30 may store various data needed by components (e.g., the processor ED20 and the sensor module ED76) of the electronic device ED01. Data may include, for example, input data and/or output data for software (e.g., the program ED40) and instructions related thereto. The memory ED30 may include the volatile memory ED32 and/or the non-volatile memory ED34.

The program ED40 may be stored as software in the memory ED30 and may include an operating system ED42, middleware ED44, and/or an application ED46.

The input device ED50 may receive a command and/or data to be used by a component (e.g., the processor ED20) of the electronic device ED01 from outside the electronic device ED01 (e.g., a user). The input device ED50 may include a microphone, a mouse, a keyboard, and/or a digital pen (e.g., a stylus pen).

The sound output device ED55 may output a sound signal to the outside of the electronic device ED01. The sound output device ED55 may include a speaker and/or a receiver. The speaker may be used for general purposes like multimedia playback or recording playback, and the receiver may be used to receive an incoming call. The receiver may be integrated as a part of the speaker or may be implemented as an independent separate device.

The display device ED60 may visually provide information to the outside of the electronic device ED01. The display device ED60 may include a display, a hologram device, or a projector and a control circuit for controlling the corresponding device. The display device ED60 may include a touch circuitry configured to sense a touch and/or a sensor circuitry configured to measure the intensity of force generated by a touch (e.g., a pressure sensor).

The audio module ED70 may convert a sound into an electric signal or convert an electric signal into a sound. The audio module ED70 may obtain a sound through

The display device ED60 may visually provide information to the outside of the electronic device ED01. The display device ED60 may include a display, a hologram device, or a projector and a control circuit for controlling the corresponding device. The display device ED60 may include a touch circuitry configured to sense a touch and/or a sensor circuitry configured to measure the intensity of force generated by a touch (e.g., a pressure sensor).

The audio module ED70 may convert a sound into an electric signal or convert an electric signal into a sound. The audio module ED70 may obtain a sound through the input device ED50 or output a sound through the sound output device ED55 and/or a speaker and/or a headphone of another electronic device (e.g., the electronic device ED02) directly or wirelessly connected to the electronic device ED01.

The sensor module ED76 may detect an operating state (e.g., power and a temperature) of the electronic device ED01 or an ambient environmental state (e.g., a user state) and generate an electrical signal and/or a data value corresponding to a sensed state. The sensor module ED76 may include a gesture sensor, a gyro sensor, an atmospheric pressure sensor, a magnetic sensor, an acceleration sensor, a grip sensor, a proximity sensor, a color sensor, an infrared ray (IR) sensor, a biometric sensor, a temperature sensor, a humidity sensor, and/or an illuminance sensor.

The interface ED77 may support one or a plurality of designated protocols that may be used to directly or wirelessly connect the electronic device ED01 to another electronic device (e.g., the electronic device ED02). The interface ED77 may include a high definition multimedia interface (HDMI), a universal serial bus (USB) interface, an SD^{™} card interface, and/or an audio interface.

A connection terminal ED78 may include a connector through which the electronic device ED01 may be physically connected to another electronic device (e.g., the electronic device ED02). The connection terminal ED78 may include an HDMI connector, a USB connector, an SD^{™} card connector, and/or an audio connector (e.g., a headphone connector).

The haptic module ED79 may convert an electrical signal into a mechanical stimulus (e.g., vibration and movement) or an electrical stimulus that the user may perceive through tactile or kinesthetic sense. The haptic module ED79 may include a motor, a piezoelectric element, and/or an electrical stimulation device.

The camera module ED80 may capture still images and moving pictures. The camera module ED80 may include a lens assembly including one or a plurality of lenses, the image sensor 1000 of FIG. 1, image signal processors, and/or flashes. The lens assembly included in the camera module ED80 may collect light emitted from an object, which is a target of capturing an image.

The power management module ED88 may manage power supplied to the electronic device ED01. The power management module ED88 may be implemented as a part of a power management integrated circuit (PMIC).

The battery ED89 may supply power to components of the electronic device ED01. The battery ED89 may include a non-rechargeable primary cell, a rechargeable secondary cell, and/or a fuel cell.

The communication module ED90 may establish a direct (wired) communication channel and/or a wireless communication channel between the electronic device ED01 and other electronic devices (e.g., the electronic device ED02, the electronic device ED04, and the server ED08) and support communication through an established communication channel. The communication module ED90 may include one or a plurality of communication processors that operate independently of the processor ED20 (e.g., an application processor) and support direct communication and/or wireless communication. The communication module ED90 may include a wireless communication module ED92 (e.g., a cellular communication module, a short-range wireless communication module, and a global navigation satellite system (GNSS) communication module) and/or a wired communication module ED94 (e.g., a local area network (LAN) communication module and a power line communication module). From among these communication modules, a corresponding communication module may communicate with another electronic device through the first network ED98 (a short-range communication network like Bluetooth^{™}, WiFi^{™} Direct, or infrared data association (IrDA)) or the second network ED99 (e.g., a cellular network, the Internet, or a computer network (e.g., LAN and WAN)). These various types of communication modules may be integrated into one component (e.g., a single chip) or implemented as a plurality of components (a plurality of chips) separate from one another. The wireless communication module ED92 may confirm and authenticate the electronic device ED01 in a communication network like the first network ED98 and/or the second network ED99 by using subscriber information (e.g., international mobile subscriber identifier (IMSI)) stored in the subscriber identifying module ED96.

The antenna module ED97 may transmit or receive signals and/or power to or from the outside (e.g., other electronic devices). An antenna may include a radiator communication module ED90 and another electronic device through a selected antenna. In addition to an antenna, other components (e.g., an RFIC) may be included as a part of the antenna module ED97.

Some of components may be connected to one another and exchange signals (e.g., commands and data) with one another through methods for communication between peripheral devices (e.g., a bus, general purpose input and output (GPIO), serial peripheral interface (SPI), and mobile industry processor interface (MIPI)).

Commands or data may be transmitted or received between the electronic device ED01 and the external electronic device ED04 through the server ED08 connected to the second network ED99. The other electronic devices ED02 and ED04 may be electronic devices of the type same as or different from that of the electronic device ED01. All or some of operations performed in the electronic device ED01 may be executed in one or a plurality of electronic devices from among other electronic devices ED02, ED04, and ED08. For example, when the electronic device ED01 needs to perform a function or a service, the electronic device ED01 may request one or a plurality of other electronic devices to perform a part or all of the function or the service instead of executing the function or the service by itself. One or a plurality of other electronic devices received the request may execute an additional function or a service related to the request and transmit a result of the execution to the electronic device ED01. To this end, cloud computing, distributed computing, and/or client-server computing technologies may be used.

Referring to FIG. 17, the camera module ED80 may include a lens assembly 1110, a flash 1120, an image sensor 1000 (e.g., the image sensor 1000 of FIG. 1), an image stabilizer 1140, a memory 1150 (e.g., a buffer memory), and/or an image signal processor 1160. The lens assembly 1110 may collect light emitted from an object, which is a target of capturing an image. The camera module ED80 may include a plurality of lens assemblies 1110. In this case, the camera module ED80 may be a dual camera, a 360 degree camera, or a spherical camera. Some of the plurality of lens assemblies 1110 may have the same lens properties (e.g., an angle of view, a focal length, auto focus, an F number, optical zoom, etc.) or may have different lens properties. The lens assembly 1110 may include a wide-angle lens or a telephoto lens.

The flash 1120 may emit light used to enhance light emitted or reflected by the object. The flash 1120 may include one or a plurality of light emitting diodes (e.g., red-green-blue (RGB) LEDs, white LEDs, infrared LEDs, and ultraviolet LEDs), and/or a xenon lamp.

The image sensor 1000 may be the image sensor described with reference to FIG. 1 and may include any one of pixel arrays 1100, 1101, 1102, and 1103 of the above-described example embodiments. The image sensor may be manufactured according to a manufacturing method described with reference to FIGS. 13A to 13F, FIGS. 14A to 14C, or FIGS. 15A to 15F. The image sensor 1000 may obtain an image corresponding to an object by converting light emitted or reflected by the object and transmitted through the lens assembly 1110 into an electrical signal. The image sensor 1000 may include one or a plurality of sensors selected from among image sensors having different properties, e.g., an RGB sensor, a black and white (BW) sensor, an IR sensor, or a UV sensor. Each of the sensors included in the image sensor 1000 may be implemented as a charged coupled device (CCD) sensor and/or a complementary metal oxide semiconductor (CMOS) sensor.

The image stabilizer 1140 may compensate for negative influences of a movement of the camera module ED80 or an electronic device ED01 including the same by moving one or a plurality of lenses included in the lens assembly 1110 or the image sensor 1000 in a particular direction or controlling operation characteristics (e.g., adjustment of a read-out timing) of the image sensor 1000 in response to the movement of the camera module ED80 or the electronic device ED01. The image stabilizer 1140 may detect a movement of the camera module ED80 or the electronic device ED01 by using a gyro sensor or an acceleration sensor provided inside or outside the camera module ED80. The image stabilizer 1140 may be optically implemented.

The memory 1150 may store a part or all of data of an image obtained through the image sensor 1000 for a subsequent image processing operation. For example, when a plurality of images are obtained at high speed, the memory 1150 may be used to store obtained original data (e.g., Bayer-Patterned data and high-resolution data) in the memory 1150, display only a low-resolution image, and transmit original data of a selected image (e.g., an image selected by a user) to the image signal processor 1160. The memory 1150 may be integrated into the memory ED30 of the electronic device ED01 or may be configured as a separate memory operated independently.

The image signal processor 1160 may perform image processing on an image obtained through the image sensor 1000 or image data stored in the memory 1150. Image processing may include depth map generation, 3D modeling, panorama generation, feature point extraction, image synthesis, and/or image compensation (noise reduction, resolution adjustment, brightness adjustment, blurring, sharpening, and softening)). The image signal processor 1160 may perform controls (e.g., exposure time control and read-out timing control) on components (e.g., the image sensor 1000) included in the camera module ED80. An image processed by the image signal processor 1160 may be stored back in the memory 1150 for further processing or provided to external components of the camera module ED80 (e.g., the memory ED30, the display device ED60, the electronic device ED02, the electronic device ED04, and the server ED08). The image signal processor 1160 may be integrated into the processor ED20 or configured as a separate processor operated independently of the processor ED20. When the image signal processor 1160 is configured as a processor separate from the processor ED20, an image processed by the image signal processor 1160 may be displayed on the display device ED60 after an additional image processing by the processor ED20.

The electronic device ED01 may include a plurality of camera modules ED80 having different properties or functions. In this case, one of the plurality of camera modules ED80 may be a wide-angle camera and the other one may be a telephoto camera. Similarly, one of the plurality of camera modules ED80 may be a front camera and the other one may be a rear camera.

The image sensor 1000 according to example embodiments may be applied to a mobile phone or a smart phone, a tablet or a smart tablet, a digital camera or a digital camcorder, a laptop computer, a television or a smart television, etc. For example, the smart phone or the smart tablet may include a plurality of high resolution cameras each equipped with a high resolution image sensor. By using high-resolution cameras, depth information regarding target objects in an image may be extracted, selective focusing of an image may be adjusted, or target objects in an image may be automatically identified.

Also, the image sensor 1000 may be applied to a smart refrigerator, a security camera, a robot, a medical camera, etc. For example, the smart refrigerator may automatically recognize food therein by using an image sensor and inform a user of information like the existence of a particular food, a type of food stocked or released through a smart phone. The security camera may provide an ultra-high resolution image and may use a high sensitivity to recognize an object or a person in an image even in a dark environment. The robot may be deployed to a disaster site or an industrial site that a person is unable to directly access and provide a high-resolution image. The medical camera may provide high-resolution images for a diagnosis or a surgery and may dynamically adjust the field of view.

Also, the image sensor 1000 may be applied to a vehicle. The vehicle may include a plurality of vehicle cameras arranged at various locations, and each vehicle camera may include an image sensor according to an example embodiment. The vehicle may provide various information about the inside or the surroundings of the vehicle to a driver using by the plurality of vehicle cameras and may provide information necessary for autonomous driving by automatically recognizing objects or people in an image.

Although aspects of the disclosure are described with reference to the example embodiments illustrated in the accompanying drawings, they are merely examples, and one of ordinary skill in the art will understand that various modifications and other equivalent example embodiments may be derived therefrom. Therefore, the disclosed example embodiments should be considered in terms of explanation, not limitation. The scope of the present invention is defined by the claims rather than the foregoing description, and all differences within the equivalent range should be interpreted as being included.

The above-described image sensor includes a color separation lens array that separates and converges light by wavelength without absorbing or blocking incident light and may exhibit high light efficiency.

In the above-described image sensor, a color separation lens array is designed to reduce process defects with respect to shape dimensions of nano-posts that may occur in a manufacturing process, and thus color separation performance may be improved.

According to the above-described manufacturing method, an image sensor having a color separation lens array having high light efficiency and excellent color separation performance may be manufactured.

It should be understood that example embodiments described herein should be considered in a descriptive sense only and not for purposes of limitation. Descriptions of features or aspects within each embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. An image sensor (1000) comprising:
a sensor substrate (110) comprising a plurality of light sensing cells;
a transparent spacer layer (120), transparent to visible light, provided on the sensor substrate (110); and
a color separation lens array (130) provided on the transparent spacer layer (120), the color separation lens array (130) comprising a plurality of nano-posts (NP) configured to change a phase of incident light according to an incident location, and the plurality of nano-posts (NP) being arranged in a plurality of layers (LE1, LE2) including a narrow critical dimension, narrow-CD, layer (LE1) and a wide critical dimension, wide-CD, layer (LE2),
a first etch stop layer (ES1) provided between the transparent spacer layer (120) and color separation lens array (130);
wherein, first nano-posts (NP1), from among the plurality of nano-posts (NP), are provided in the narrow-CD layer (LE1), and second nano-posts (NP2), from among the plurality of nano-posts (NP), are provided in the wide-CD layer (LE2),
wherein the first nano-posts (NP1) include one or more third nano-posts having widths less than a reference width and one or more fourth nano-posts having widths greater than or equal to the reference width,
wherein the second nano-posts (NP2) have widths equal to or greater than the reference width,
wherein the reference width is greater than or equal to 80 nm and less than or equal to 200 nm; and
wherein the narrow-CD layer (LE1) is provided closer to the transparent spacer layer than the wide-CD layer (LE2).

2. The image sensor (1000) of claim 1, wherein a smallest width from among the widths of first nano-posts (NP1) arranged in the narrow-CD layer (LE1) is 50 nm or greater.

3. The image sensor (1000) of claim 1 or 2, wherein a smallest width from among widths of second nano-posts (NP2) arranged in the wide-CD layer (LE2) is 100 nm or greater.

4. The image sensor (1000) of claim 1, further comprising a second etch stop layer (ES2) provided between the wide-CD layer (LE2) and the narrow-CD layer (LE1).

5. The image sensor (1000) of claim 4, wherein the one or more fourth nano-posts in the narrow-CD layer (LE1) are directly connected to the second nano posts in the wide-CD layer (LE2) in a vertical direction, and optionally wherein a width of the one or more fourth nano-posts connected to each other in the vertical direction is 100 nm or greater.

6. The image sensor (1000) of claim 5, wherein the second nano-posts (NP2) of the wide-CD layer (LE2) have a first height lower than a second height of the first nano-posts of the narrow-CD layer (LE1), and optionally wherein the first height of the nano-posts of the wide-CD layer (LE2) is 400 nm or less.

7. The image sensor (1000) of any of claims 1 to 4, wherein the one or more fourth nano-posts in the narrow-CD layer (LE1) are directly connected to the second nano posts (NP2) in the wide-CD layer (LE2) in a vertical direction.

8. The image sensor (1000) of claim 1, wherein no etch stop layer is provided between the narrow-CD layer (LE1) and the wide-CD layer (LE2).

9. The image sensor (1000) of any preceding claim, wherein the color separation lens array (130) is configured to separate light of a first wavelength and light of a second wavelength from incident light and converge the light of the first wavelength to a first pixel (PX1) and the light of the second wavelength to a second pixel (PX2) of the plurality of light sensing cells.

10. The image sensor (1000) of any preceding claim, further comprising a color filter array (170) provided between the transparent spacer layer (120) and the sensor substrate (110).

11. An electronic device (ED01) comprising:
an image sensor (1000) according to any preceding claim configured to convert an optical image into an electrical signal; and
a processor (ED20) configured to control an operation of the image sensor (1000) and process the electrical signal generated by the image sensor (1000).

12. A method of manufacturing an image sensor (1000), the method comprising:
forming a spacer layer (120) on a sensor substrate (110) comprising a plurality of light sensing cells;
forming a first etch stop layer (ES1) on the spacer layer (120);
forming a first material layer (LM1) on the first etch stop layer (ES1);
forming a second material layer (LM2) on the first material layer (LM1);
patterning the first material layer (LM1) and the second material layer (LM2) together to form a plurality of holes (HO) having a depth penetrating through the first material layer
(LM1) and the second material layer (LM2) and having a width greater than a reference width, wherein the reference width is greater than or equal to 80 nm and less than or equal to 200 nm; and
filling the plurality of holes (HO) with a third material having a first refractive index different from a second refractive index of the first material layer (LM1) and a third refractive index of the second material layer (LM2).

13. The method of claim 12, further comprising forming a second etch stop layer (ES2) between the first material layer (LM1) and the second material layer (LM2), and optionally wherein, in the patterning operation, a plurality of holes (HO1) having a width less than the reference width and a depth exposing the second etch stop layer (ES2) are formed together with the plurality of holes (HO2) having a width greater than the reference width.

## Patentansprüche

1. Bildsensor (1000), umfassend:
ein Sensorsubstrat (110), das eine Vielzahl von Lichterfassungszellen umfasst;
eine transparente Abstandsschicht (120), die transparent für sichtbares Licht ist, die auf dem Sensorsubstrat (110) bereitgestellt ist; und
eine Farbtrennlinsenanordnung (130), die auf der transparenten Abstandsschicht (120) bereitgestellt ist, wobei die Farbtrennlinsenanordnung (130) eine Vielzahl von Nanopfosten (NP) umfasst, die dazu konfiguriert ist, eine Phase von einfallendem Licht gemäß einer Einfallsstelle zu ändern, und die Vielzahl von Nanopfosten (NP) in einer Vielzahl von Schichten (LE1, LE2) angeordnet ist, die eine Schmal-CD-Schicht mit schmaler kritischer Abmessung (LE1) und eine Breit-CD-Schicht mit breiter kritischer Abmessung (LE2) beinhaltet,
eine erste Ätzstoppschicht (ES1), die zwischen der transparenten Abstandsschicht (120) und der Farbtrennlinsenanordnung (130) bereitgestellt ist;
wobei erste Nanopfosten (NP1) aus der Vielzahl von Nanopfosten (NP) in der Schmal-CD-Schicht (LE1) bereitgestellt sind und zweite Nanopfosten (NP2) aus der Vielzahl von Nanopfosten (NP) in der Breit-CD-Schicht (LE2) bereitgestellt sind,
wobei die ersten Nanopfosten (NP1) einen oder mehrere dritte Nanopfosten mit Breiten weniger als eine Referenzbreite und einen oder mehrere vierte Nanopfosten mit Breiten größer als die oder gleich der Referenzbreite beinhalten,
wobei die zweiten Nanopfosten (NP2) Breiten gleich der oder größer als die Referenzbreite aufweisen,
wobei die Referenzbreite größer als oder gleich 80 nm und weniger als oder gleich 200 nm ist; und
wobei die Schmal-CD-Schicht (LE1) näher an der transparenten Abstandsschicht als die Breit-CD-Schicht (LE2) bereitgestellt ist.

2. Bildsensor (1000) nach Anspruch 1, wobei eine kleinste Breite unter den Breiten der ersten Nanopfosten (NP1), die in der Schmal-CD-Schicht (LE1) angeordnet sind, 50 nm oder größer ist.

3. Bildsensor (1000) nach Anspruch 1 oder 2, wobei eine kleinste Breite unter 30 Breiten der zweiten Nanopfosten (NP2), die in der Breit-CD-Schicht (LE2) angeordnet sind, 100 nm oder größer ist.

4. Bildsensor (1000) nach Anspruch 1, ferner umfassend eine zweite Ätzstoppschicht (ES2), die zwischen der Breit-CD-Schicht (LE2) und der Schmal-CD-Schicht (LE1) bereitgestellt ist.

5. Bildsensor (1000) nach Anspruch 4, wobei der eine oder die mehreren vierten Nanopfosten in der Schmal-CD-Schicht (LE1) direkt mit den zweiten Nanopfosten in der Breit-CD-Schicht (LE2) in einer vertikalen Richtung verbunden sind, und wobei optional eine Breite von dem einen oder den mehreren vierten Nanopfosten, die in der vertikalen Richtung miteinander verbunden sind, 100 nm oder größer ist.

6. Bildsensor (1000) nach Anspruch 5, wobei die zweiten Nanopfosten (NP2) der Breit-CD-Schicht (LE2) eine erste Höhe aufweisen, die niedriger als eine zweite Höhe der ersten Nanopfosten der Schmal-CD-Schicht (LE1) ist, und wobei optional die erste Höhe der Nanopfosten der Breit-CD-Schicht (LE2) 400 nm oder weniger ist.

7. Bildsensor (1000) nach einem der Ansprüche 1 bis 4, wobei der eine oder die mehreren vierten Nanopfosten in der Schmal-CD-Schicht (LE1) direkt mit den zweiten Nanopfosten (NP2) in der Breit-CD-Schicht (LE2) in einer vertikalen Richtung verbunden sind.

8. Bildsensor (1000) nach Anspruch 1, wobei keine Ätzstoppschicht zwischen der Schmal-CD-Schicht (LE1) und der Breit-CD-Schicht (LE2) bereitgestellt ist.

9. Bildsensor (1000) nach einem vorhergehenden Anspruch, wobei die Farbtrennlinsenanordnung (130) dazu konfiguriert ist, Licht einer ersten Wellenlänge und Licht einer zweiten Wellenlänge von einfallendem Licht zu trennen und das Licht der ersten Wellenlänge auf ein erstes Pixel (PX1) und das Licht der zweiten Wellenlänge auf ein zweites Pixel (PX2) aus der Vielzahl von Lichterfassungszellen zu konvergieren.

10. Bildsensor (1000) nach einem vorhergehenden Anspruch, ferner umfassend eine Farbfilteranordnung (170), die zwischen der transparenten Abstandsschicht (120) und dem Sensorsubstrat (110) bereitgestellt ist.

11. Elektronische Vorrichtung (ED01), umfassend:
einen Bildsensor (1000) gemäß einem vorhergehenden Anspruch, der dazu konfiguriert ist, ein optisches Bild in ein elektrisches Signal umzuwandeln; und
einen Prozessor (ED20), der dazu konfiguriert ist, einen Vorgang des Bildsensors (1000) zu steuern und das elektrische Signal, das durch den Bildsensor (1000) erzeugt wird, zu verarbeiten.

12. Verfahren zur Herstellung eines Bildsensors (1000), wobei das Verfahren Folgendes umfasst:
Bilden einer Abstandsschicht (120) auf einem Sensorsubstrat (110), das eine Vielzahl von Lichterfassungszellen umfasst;
Bilden einer ersten Ätzstoppschicht (ES1) auf der Abstandsschicht (120);
Bilden einer ersten Materialschicht (LM1) auf der ersten Ätzstoppschicht (ES1);
Bilden einer zweiten Materialschicht (LM2) auf der ersten Materialschicht (LM1);
Strukturieren der ersten Materialschicht (LM1) und der zweiten Materialschicht (LM2) zusammen, um eine Vielzahl von Löchern (HO) mit einer Tiefe zu bilden, die durch die erste Materialschicht (LM1) und die zweite Materialschicht (LM2) dringt und eine Breite aufweist, die größer als eine Referenzbreite ist, wobei die Referenzbreite größer als oder gleich 80 nm und weniger als oder gleich 200 nm ist; und
Füllen der Vielzahl von Löchern (HO) mit einem dritten Material, das einen ersten Brechungsindex aufweist, der sich von einem zweiten Brechungsindex der ersten Materialschicht (LM1) und einem dritten Brechungsindex der zweiten Materialschicht (LM2) unterscheidet.

13. Verfahren nach Anspruch 12, ferner umfassend Bilden einer zweiten Ätzstoppschicht (ES2) zwischen der ersten Materialschicht (LM1) und der zweiten Materialschicht (LM2), und wobei optional bei dem Strukturierungsvorgang eine Vielzahl von Löchern (HO1) mit einer Breite, die weniger als die Referenzbreite ist, und einer Tiefe, welche die zweite Ätzstoppschicht (ES2) freilegt, zusammen mit der Vielzahl von Löchern (HO2) mit einer Breite, die größer als die Referenzbreite ist, gebildet wird.

## Revendications

1. Capteur d'image (1000) comprenant :
un substrat de capteur (110) comprenant une pluralité de cellules de détection de lumière ;
une couche d'espacement transparente (120), transparente à la lumière visible, prévue sur le substrat de capteur (110) ; et
un réseau de lentilles de séparation de couleurs (130) prévu sur la couche d'espacement transparente (120), le réseau de lentilles de séparation de couleurs (130) comprenant une pluralité de nano-poteaux (NP) configurés pour changer une phase de lumière incidente selon un emplacement incident, et la pluralité de nano-poteaux (NP) étant agencés en une pluralité de couches (LE1, LE2) comprenant une couche étroite de dimension critique, DC-étroite, (LE1) et une couche dimension critique large, DC-large, (LE2),
une première couche d'arrêt de gravure (ES1) prévue entre la couche d'espacement transparente (120) et le réseau de lentilles de séparation de couleurs (130) ;
dans lequel des premiers nano-poteaux (NP1), parmi la pluralité de nano-poteaux (NP), sont prévus dans la couche DC-étroite (LE1), et des deuxièmes nano-poteaux (NP2), parmi la pluralité de nano-poteaux (NP), sont prévus dans la couche DC-large (LE2),
dans lequel les premiers nano-poteaux (NP1) comprennent un ou plusieurs troisièmes nano-poteaux comportant des largeurs inférieures à une largeur de référence et un ou plusieurs quatrièmes nano-poteaux comportant des largeurs supérieures ou égales à la largeur de référence,
dans lequel les deuxièmes nano-poteaux (NP2) comportent des largeurs égales ou supérieures à la largeur de référence,
dans lequel la largeur de référence est supérieure ou égale à 80 nm et inférieure ou égale à 200 nm ; et
dans lequel la couche DC-étroite (LE1) est prévue plus proche de la couche d'espacement transparente que la couche DC-large (LE2).

2. Capteur d'image (1000) de la revendication 1, dans lequel une largeur la plus petite parmi les largeurs de premiers nano-poteaux (NP1) agencés dans la couche DC-étroite (LE1) est de 50 nm ou supérieure.

3. Capteur d'image (1000) de la revendication 1 ou 2, dans lequel une largeur la plus petite parmi des largeurs de deuxièmes nano-poteaux (NP2) agencés dans la couche DC-large (LE2) est de 100 nm ou supérieure.

4. Capteur d'image (1000) de la revendication 1, comprenant en outre une seconde couche d'arrêt de gravure (ES2) prévue entre la couche DC-large (LE2) et la couche DC-étroite (LE1).

5. Capteur d'image (1000) de la revendication 4, dans lequel les un ou plusieurs quatrièmes nano-poteaux dans la couche DC-étroite (LE1) sont directement reliés aux deuxièmes nano-poteaux dans la couche DC-large (LE2) dans une direction verticale, et éventuellement dans lequel une largeur des un ou plusieurs quatrièmes nano-poteaux reliés les uns aux autres dans la direction verticale est de 100 nm ou supérieure.

6. Capteur d'image (1000) de la revendication 5, dans lequel les deuxièmes nano-poteaux (NP2) de la couche DC-large (LE2) comportent une première hauteur inférieure à une seconde hauteur des premiers nano-poteaux de la couche DC-étroite (LE1), et éventuellement dans lequel la première hauteur des nano-poteaux de la couche DC-large (LE2) est de 400 nm ou inférieure.

7. Capteur d'image (1000) de l'une quelconque des revendications 1 à 4, dans lequel les un ou plusieurs quatrièmes nano-poteaux dans la couche DC-étroite (LE1) sont directement reliés aux deuxièmes nano-poteaux (NP2) dans la couche DC-large (LE2) dans une direction verticale.

8. Capteur d'image (1000) de la revendication 1, dans lequel aucune couche d'arrêt de gravure n'est prévue entre la couche DC-étroite (LE1) et la couche DC-large (LE2).

9. Capteur d'image (1000) d'une quelconque revendication précédente, dans lequel le réseau de lentilles de séparation de couleurs (130) est configuré pour séparer de la lumière d'une première longueur d'onde et de la lumière d'une seconde longueur d'onde de la lumière incidente et faire converger la lumière de la première longueur d'onde vers un premier pixel (PX1) et la lumière de la seconde longueur d'onde vers un second pixel (PX2) de la pluralité de cellules de détection de lumière.

10. Capteur d'image (1000) d'une quelconque revendication précédente, comprenant en outre un réseau de filtres colorés (170) prévu entre la couche d'espacement transparente (120) et le substrat de capteur (110).

11. Dispositif électronique (ED01) comprenant :
un capteur d'image (1000) selon une quelconque revendication précédente, configuré pour convertir une image optique en un signal électrique ; et
un processeur (ED20) configuré pour commander une opération du capteur d'image (1000) et traiter le signal électrique généré par le capteur d'image (1000).

12. Procédé de fabrication d'un capteur d'image (1000), le procédé comprenant :
la formation d'une couche d'espacement (120) sur un substrat de capteur (110) comprenant une pluralité de cellules de détection de lumière ;
la formation d'une première couche d'arrêt de gravure (ES1) sur la couche d'espacement (120) ;
la formation d'une première couche de matériau (LM1) sur la première couche d'arrêt de gravure (ES1) ;
la formation d'une seconde couche de matériau (LM2) sur la première couche de matériau (LM1) ;
la formation de motifs sur la première couche de matériau (LM1) et la seconde couche de matériau (LM2) pour former une pluralité de trous (HO) comportant une profondeur pénétrant à travers la première couche de matériau (LM1) et la seconde couche de matériau (LM2) et comportant une largeur supérieure à une largeur de référence, dans lequel
la largeur de référence est supérieure ou égale à 80 nm et inférieure ou égale à 200 nm ; et
le remplissage de la pluralité de trous (HO) avec un troisième matériau comportant un premier indice de réfraction différent d'un deuxième indice de réfraction de la première couche de matériau (LM1) et un troisième indice de réfraction de la seconde couche de matériau (LM2).

13. Procédé de la revendication 12, comprenant en outre la formation d'une seconde couche d'arrêt de gravure (ES2) entre la première couche de matériau (LM1) et la seconde couche de matériau (LM2), et éventuellement dans lequel, lors de l'opération de formation de motifs, une pluralité de trous (HO1) comportant une largeur inférieure à la largeur de référence et une profondeur exposant la seconde couche d'arrêt de gravure (ES2) sont formés avec la pluralité de trous (HO2) comportant une largeur supérieure à la largeur de référence.
